# EUROPEAN PATENT APPLICATION

(11) **EP 4 486 090 A1**
(43) Date of publication of application: **01.01.2025**
(21) Application number: 24183714.5
(22) Date of filing: 21.06.2024
(51) Int. Cl.: H10K 59/121, H10K 59/80, H10K 71/00

(54) **DISPLAY DEVICE AND METHOD FOR MANUFACTURING THE DISPLAY DEVICE**

(30) Priority: 27.06.2023 KR 20230082577
(71) Applicant: Samsung Display Co., Ltd., Yongin-si, Gyeonggi-do 17113 (KR)
(72) Inventor: Kim, Wan Jung, Yongin-si, Gyeonggi-do (KR); Lee, So Young, Yongin-si, Gyeonggi-do (KR); Nam, Kyung Ah, Yongin-si, Gyeonggi-do (KR); Mun, Hyo Young, Yongin-si, Gyeonggi-do (KR); Seo, Seok Hoon, Yongin-si, Gyeonggi-do (KR); Um, Yi Seul, Yongin-si, Gyeonggi-do (KR); Yun, Dae Sang, Yongin-si, Gyeonggi-do (KR); Lee, Young Hoon, Yongin-si, Gyeonggi-do (KR)
(74) Representative: Gulde & Partner

(57) **Abstract**

A display device includes: a substrate (SUB) including a first surface (US), a second surface (BS) facing the first surface (US), and a first side surface (SS1) between the first surface (US) and the second surface (BS); a plurality of light emitting elements (LEL) on the first surface (US); and a protection dam (CPD) on the first surface (US), and adjacent to an edge of the substrate (SUB), where the protection dam (CPD) includes a lower portion (BTP) and an upper portion (UPP) on the lower portion (BTP), and a width (UPP_W1) of the upper portion (UPP) is greater than a maximum width (BTP_W1) of the lower portion (BTP).

## Description

### BACKGROUND

### 1. Technical Field

The present disclosure relates to a display device and a method for manufacturing the display device.

### 2. Description of the Related Art

With the advance of information-oriented society, more and more demands are placed on display devices for displaying images in various ways. The display device may be a flat panel display device such as a liquid crystal display, a field emission display and a light emitting display.

The display device includes a display area for displaying an image and a non-display area disposed around the display area, for example, to surround the display area. The width of the non-display area has been gradually reduced to increase immersion in the display area and enhance the aesthetics of the display device.

Meanwhile, in the manufacturing process of the display device, the display device may be formed by cutting a mother substrate along a plurality of display cells formed on the mother substrate including the plurality of display cells.

The non-display area may include a first non-display area in which lines and circuits for driving the display area are disposed, and a second non-display area corresponding to a margin for a cutting process in a manufacturing process of a display device. Since there is a limit to reducing lines and circuits in the first non-display area, a method of reducing the width of the second non-display area is being researched.

### SUMMARY

Aspects of the present disclosure provide a display device that minimizes a width of a non-display area and a method for manufacturing the display device.

Aspects of the present disclosure also provide a display device having improved reliability by preventing permeation of an etchant and a method for manufacturing the display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an aspect of the present disclosure, there is provided a display device including: a substrate including a first surface, a second surface facing the first surface, a first side surface between the first surface and the second surface, and a first inclined surface between the first side surface and the second surface, a plurality of light emitting elements on the first surface, and a protection dam on the first surface, and adjacent to an edge of the substrate, wherein the protection dam includes a lower portion and an upper portion on the lower portion, and a width of the upper portion is greater than a maximum width of the lower portion.

In an embodiment, a first extension line connecting a lower end of the upper portion to a lower end of the lower portion and a second extension line connecting an opposite lower end of the upper portion to an opposite lower end of the lower portion may form a reverse tapered shape.

In an embodiment, the upper portion may include a first tip protruding from the lower portion.

In an embodiment, the display device may further include a first upper layer on the protection dam, where the first upper layer may cover a top surface and a side surface of the protection dam, and the first upper layer may include a second tip along a shape of the first tip.

In an embodiment, the display device may further include, a thin film transistor layer on the first surface, and an encapsulation layer on the plurality of light emitting elements, where each of the thin film transistor layer and the encapsulation layer may include at least one of an inorganic layer or an organic layer, and the first upper layer may be the at least one of the inorganic layer or the organic layer of the thin film transistor layer or the encapsulation layer.

In an embodiment, the protection dam may have a reverse tapered shape.

In an embodiment, the protection dam may have a reverse trapezoidal shape.

In an embodiment, the display device may further include a first upper layer on the protection dam, where the first upper layer may include: a remaining portion on a top surface of the protection dam, and an extension portion on at least one side of the protection dam, and the first upper layer may define a cavity portion between the remaining portion and the extension portion.

In an embodiment, the remaining portion and the extension portion may overlap the protection dam in a thickness direction.

In an embodiment, the display device may further include a second upper layer on the first upper layer, wherein the second upper layer may be disposed in at least a part of the cavity portion defined in the first upper layer.

In an embodiment, the protection dam may contain at least one organic material of polyimide, polyamide, polyethylene, polypropylene, polyvinyl chloride ("PVC"), polyester, polyolefin, carbon fiber, and carbon fiber-reinforced epoxy resin.

In an embodiment, the protection dam may include silicon nitride (SiNx) as an inorganic material.

In an embodiment, the protection dam may contain at least one metal of vanadium, niobium, tantalum, chromium, molybdenum, tungsten, nickel, titanium, palladium, platinum, copper, silver, gold, aluminum, titanium/tungsten (Ti/W), nickel/chromium (Ni/Cr), titanium nitride (TiN), copper/zeolite (Cu/Z), carbon steel, chromium-nickel-molybdenum steel, and a nickel-chromium-iron alloy.

In an embodiment, at least a part of the protection dam may be configured to react with an etchant to be oxidized, and at least a part of the oxidized protection dam may form a barrier layer.

In an embodiment, the protection dam may surround at least a part of a display area in which the plurality of light emitting elements may be disposed.

In an embodiment, the display device may further include a crack dam between the protection dam and the display area.

In an embodiment, the protection dam may be configured to prevent an etchant from moving toward the plurality of light emitting elements from the edge.

In an embodiment, the substrate may define a through-hole penetrating the first surface and the second surface, and the substrate further may include a second side surface between the first surface and the second surface at an edge of the through-hole, and a second inclined surface between the second side surface and the second surface, where a length of the first inclined surface may be shorter than a length of the second inclined surface.

In an embodiment, an angle between the first inclined surface and the second surface may be smaller than an angle between the second inclined surface and the second surface.

In an embodiment, the substrate may be made of glass.

According to an aspect of the present disclosure, there is provided a display device including: a substrate including a first surface and a second surface, which face each other, where the substrate defines a through-hole penetrating the first surface and the second surface; a plurality of light emitting elements on the first surface; and a protection dam on the first surface, and adjacent to an edge of the through-hole. At the edge of the through-hole, the substrate further includes: a first side surface between the first surface and the second surface, and a first inclined surface between the first side surface and the second surface, and the protection dam includes a lower portion and an upper portion on the lower portion, and a width of the upper portion is greater than a maximum width of the lower portion.

In an embodiment, the protection dam may have a reverse tapered shape.

In an embodiment, the through-hole may be surrounded by a display area in which the light emitting elements may be disposed.

According to an aspect of the present disclosure, there is provided a method for manufacturing a display device, including: forming a plurality of display cells on a first surface of a mother substrate, forming a plurality of first laser irradiation areas defined along edges of the plurality of display cells by irradiating a first laser onto a second surface facing the first surface of the mother substrate, and cutting the mother substrate along the plurality of first laser irradiation areas while spraying an etchant on the second surface of the mother substrate without a mask to reduce a thickness of the mother substrate, where a protection dam is between the edges of the plurality of display cells and the plurality of first laser irradiation areas, the protection dam includes a lower portion and an upper portion on the lower portion, and a width of the upper portion is greater than a maximum width of the lower portion.

In an embodiment, the protection dam may be configured to prevent the etchant from permeating toward a corresponding display cell of the plurality of display cells.

In an embodiment, the method may further include forming a plurality of second laser irradiation areas for forming a through-hole in each of the plurality of display cells by irradiating a second laser onto the second surface of the mother substrate, where in the cutting of the mother substrate, the through-hole may be formed along the plurality of second laser irradiation areas by the etchant sprayed without the mask.

According to an aspect of the present disclosure, there is provided a display device including: a substrate including a first surface, a second surface facing the first surface, and a first side surface between the first surface and the second surface, a plurality of light emitting elements on the first surface, and a protection dam disposed on the first surface, and adjacent to an edge of the substrate, wherein the protection dam includes a lower portion and an upper portion on the lower portion, and a width of the upper portion is greater than a maximum width of the lower portion.

According to the display device and the method for manufacturing the display device according to at least one embodiment of the present disclosure, the width of the non-display area may be effectively minimized.

According to the display device and the method for manufacturing the display device according to one at least embodiment of the present disclosure, the permeation of the etchant may be prevented, and thus the reliability may be effectively improved.

However, effects according to the embodiments of the present disclosure are not limited to those exemplified above and various other effects are incorporated herein.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view showing a display device according to an embodiment;
FIG. 2 is a plan view illustrating a display panel and a driving IC according to an embodiment;
FIG. 3 is a cross-sectional view taken along line X1-X1' of FIG. 1;
FIG. 4 is a cross-sectional view showing the display device of FIG. 3 in a bent state;
FIG. 5 is a cross-sectional view illustrating an example of a display area of a display device according to an embodiment;
FIG. 6 is an enlarged view of area A of FIG. 2;
FIG. 7 is a cross-sectional view taken along line X2-X2' of FIG. 6;
FIG. 8 is an enlarged view of area C of FIG. 7;
FIG. 9 is an enlarged view of area D of FIG. 8;
FIG. 10 is a cross-sectional view illustrating a part of a display device according to another embodiment;
FIG. 11 is a cross-sectional view illustrating a part of a display device according to still another embodiment;
FIG. 12 is an enlarged view of area B of FIG. 2;
FIG. 13 is a cross-sectional view taken along line X3-X3' in FIG. 12;
FIG. 14 is an enlarged view of area E of FIG. 13;
FIG. 15 is a cross-sectional view illustrating a protection dam and the surroundings thereof according to another embodiment;
FIG. 16 is a cross-sectional view illustrating a protection dam and the surroundings thereof according to still another embodiment;
FIG. 17 is a flowchart showing a method for manufacturing a display device according to an embodiment;
FIG. 18 is a diagram illustrating the depth of a laser irradiation area formed by a laser processing device according to an embodiment;
FIGS. 19 to 24 are perspective views illustrating a method for manufacturing a display device according to an embodiment; and
FIGS. 25 to 34 are cross-sectional views illustrating a method for manufacturing a display device according to an embodiment.

### DETAILED DESCRIPTION

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein. Hereinafter, embodiments of the present disclosure will be described in detail with reference to the accompanying drawings.

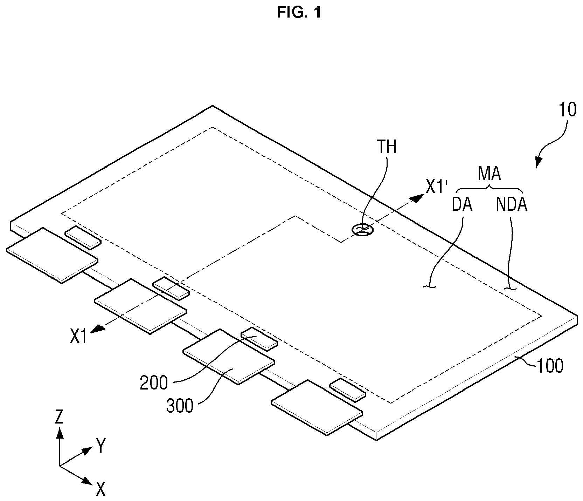

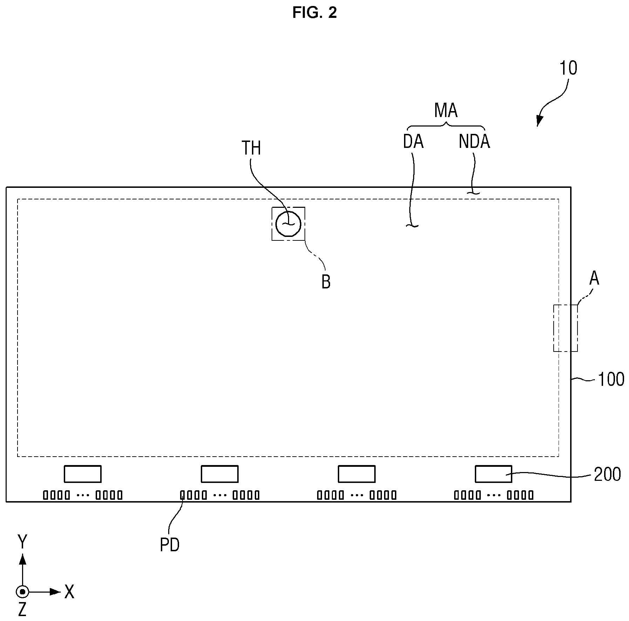

FIG. 1 is a perspective view showing a display device according to an embodiment. FIG. 2 is a plan view illustrating a display panel and a driving IC according to an embodiment. As used herein, the "plan view" is a view in the Z-axis direction (e.g., thickness direction of the substrate.)

Referring to FIGS. 1 and 2, a display device 10 is a device for displaying a moving image or a still image. The display device 10 may be used as a display screen of various devices, such as a television, a laptop computer, a monitor, a billboard and an Internet-of-Things ("IOT") device, as well as portable electronic devices such as a mobile phone, a smartphone, a tablet personal computer ("PC"), a smart watch, a watch phone, a mobile communication terminal, an electronic notebook, an electronic book, a portable multimedia player ("PMP"), a navigation device and an ultra-mobile PC ("UMPC").

The display device 10 according to an embodiment may be a light emitting display device such as an organic light emitting display using an organic light emitting diode, a quantum dot light emitting display including a quantum dot light emitting layer, an inorganic light emitting display including an inorganic semiconductor, and a micro or nano light emitting display using a micro or nano light emitting diode ("LED"). In the following description, it is assumed that the display device 10 is an organic light emitting display device, but the present disclosure is not limited thereto.

The display device 10 according to an embodiment may include a display panel 100, a driving integrated circuit ("IC") 200, and a circuit board 300.

The display panel 100 may have a rectangular shape, in a plan view, having long sides in a first direction (X-axis direction) and short sides in a second direction (Y-axis direction) crossing the first direction (X-axis direction). A corner formed by the long side in the first direction (X-axis direction) and the short side in the second direction (Y-axis direction) may be right-angled or rounded with a curvature. The planar shape of the display panel 100 is not limited to the rectangular shape, and may be another polygonal shape, a circular shape or an elliptical shape.

In the illustrated figure, the first direction (X-axis direction) and the second direction (Y-axis direction) cross each other as horizontal directions. For example, the first direction (X-axis direction) and the second direction (Y-axis direction) may be orthogonal to each other. In addition, the third direction (Z-axis direction) crosses both the first direction (X-axis direction) and the second direction (Y-axis direction), and may be, for example, perpendicular directions orthogonal to each other. In the present specification, directions indicated by arrows of the first to third directions DR1, DR2, and DR3 (X-axis direction, Y-axis direction, and Z-axis direction) may be referred to as one side, and the opposite directions thereto may be referred to as the other side.

The display panel 100 may be formed to be flat, but is not limited thereto. For another example, the display panel 100 may include a curved portion formed at left and right ends and having a constant curvature or a varying curvature. In addition, the display panel 100 may be formed flexibly so that it can be curved, bent, folded, or rolled.

The display panel 100 may include a display area DA for displaying an image and a non-display area NDA disposed around the display area DA. The display area DA and the non-display area NDA may constitute a main area MA.

The display area DA may occupy most of the area of the display panel 100. The display area DA may be disposed at the center of the display panel 100. Pixels each including a plurality of emission areas may be disposed in the display area DA to display an image.

The non-display area NDA may be disposed adjacent to the display area DA. The non-display area NDA may be an area outside the display area DA. The non-display area NDA may be disposed to surround the display area DA. The non-display area NDA may be an edge area of the display panel 100.

Display pads PD may be arranged in the non-display area NDA to be connected to the circuit boards 300. The display pads PD may be disposed on one side edge of the display panel 100. In an embodiment, for example, the display pads PD may be disposed at the lower edge of the display panel 100.

The driving ICs 200 may generate the data voltages, the source voltages, the scan timing signals, and the like. The driving ICs 200 may output the data voltages, the source voltages, the scan timing signals, and the like.

The driving ICs 200 may be disposed between the display pads PD and the display area DA in the non-display area NDA. Each of the driving ICs 200 may be attached to the non-display area NDA of the display panel 100 in a chip on glass ("COG") method. Alternatively, each of the driving ICs 200 may be attached to the circuit board 300 in a chip on plastic ("COP") method.

The circuit boards 300 may be disposed on the display pads PD disposed on one side edge of the display panel 100. The circuit boards 300 may be attached to the display pads PD by using a conductive adhesive member such as an anisotropic conductive film and an anisotropic conductive adhesive. Accordingly, the circuit boards 300 may be electrically connected to the signal lines of the display panel 100. The circuit boards 300 may be a flexible printed circuit board or a flexible film such as a chip on film.

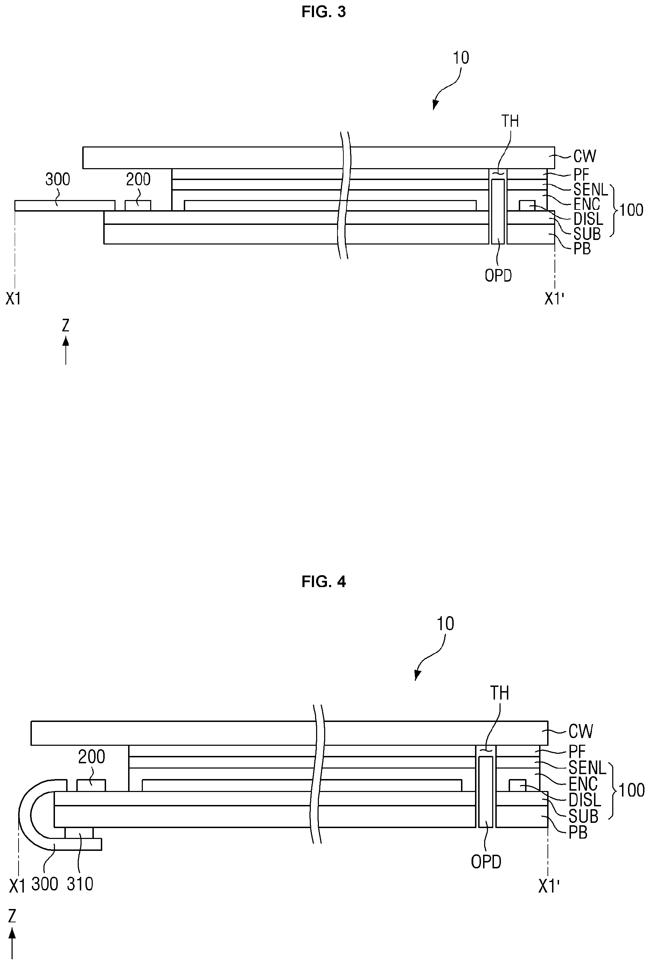

FIG. 3 is a cross-sectional view taken along line X1-X1' of FIG. 1. FIG. 4 is a cross-sectional view showing the display device of FIG. 3 in a bent state.

Referring to FIGS. 3 and 4 in addition to FIGS. 1 and 2, the display device 10 according to an embodiment may include the display panel 100, a polarizing film PF, a cover window CW, a panel lower cover PB, the driving IC 200, and the circuit board 300. The display panel 100 may include a substrate SUB, a display layer DISL, an encapsulation layer ENC, and a sensor electrode layer SENL.

The substrate SUB may have a hard material. In an embodiment, for example, the substrate SUB may be made of glass. The substrate SUB may be formed of or include ultra thin glass ("UTG") having a thickness of approximately 500 micrometers (µm) or less. Preferably, the thickness of the substrate SUB may be approximately 200 µm. In another embodiment, the substrate SUB may include a first substrate made of a hard material and a second substrate made of a polymer resin made of a flexible material.

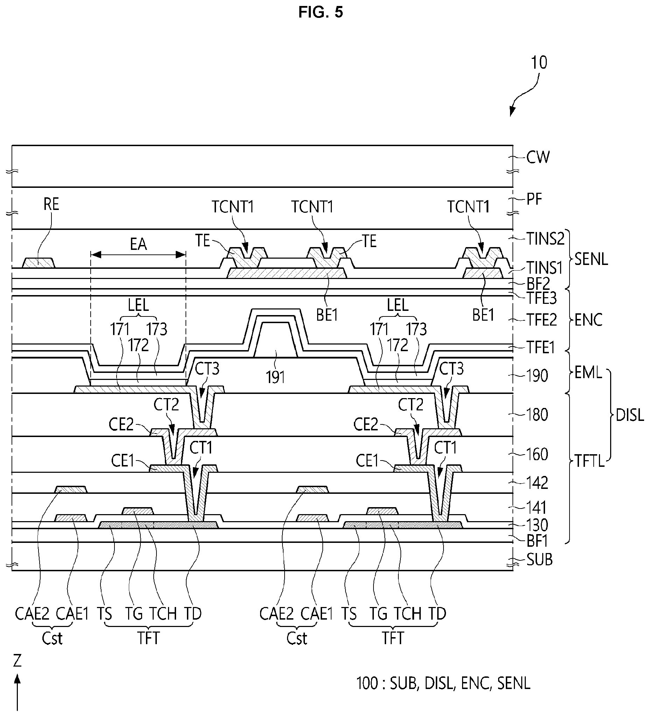

The display layer DISL may be disposed on the first surface of the substrate SUB. The display layer DISL may be a layer for displaying an image. The display layer DISL may include a thin film transistor layer TFTL (see FIG. 5) in which thin film transistors are formed, and a light emitting element layer EML (see FIG. 5) in which light emitting elements emitting light are disposed in the emission areas.

In the display area DA of the display layer DISL, scan lines, data lines, power lines, or the like for the emission areas to emit light may be disposed. In the non-display area NDA of the display layer DISL, a scan driving circuit unit outputting scan signals to the scan lines, fan-out lines connecting the data lines and the driving IC 200, and the like may be disposed.

The encapsulation layer ENC may be a layer for encapsulating the light emitting element layer of the display layer DISL to prevent permeation of oxygen or moisture into the light emitting element layer of the display layer DISL. The encapsulation layer ENC may be disposed on the display layer DISL. The encapsulation layer ENC may be disposed on the top surfaces and the side surfaces of the display layer DISL. The encapsulation layer ENC may be disposed to cover the display layer DISL.

The sensor electrode layer SENL may be disposed on the display layer DISL. The sensor electrode layer SENL may include sensor electrodes. The sensor electrode layer SENL may sense a user's touch using sensor electrodes.

The polarizing film PF may be disposed on the sensor electrode layer SENL. The polarizing film PF may be disposed on the display panel 100 to reduce reflection of external light. The polarizing film PF may include a first base member, a linear polarization plate, a phase retardation film such as a quarter-wave plate (λ/4 plate), and a second base member. The first base member, the phase retardation film, the linear polarization plate, and the second base member of the polarizing film PF may be sequentially stacked on the display panel 100.

The cover window CW may be disposed on the polarizing film PF. The cover window CW may be attached on the polarizing film PF by a transparent adhesive member such as an optically clear adhesive ("OCA") film.

The panel lower cover PB may be disposed on a second surface of the substrate SUB of the display panel 100. The second surface of the substrate SUB may be a surface opposite to the first surface. The panel lower cover PB may be attached to the second surface of the substrate SUB of the display panel 100 through an adhesive member. The adhesive member may be a pressure sensitive adhesive ("PSA").

The lower panel cover PB may include at least one of a light blocking member for absorbing light incident from the outside, a buffer member for absorbing an impact from the outside, or a heat dissipation member for efficiently dissipating heat from the display panel 100.

The driving IC 200 and the circuit board 300 may be bent downward of the display panel 100 as illustrated in FIG. 4. The circuit board 300 may be attached to the bottom surface of the panel lower cover PB by an adhesive member 310. The adhesive member 310 may be a pressure sensitive adhesive.

The display device 10 may define a through-hole TH therein and include an optical device OPD disposed in the through-hole TH.

The through-hole TH may be a hole capable of transmitting light, and may be a physical hole penetrating not only the display panel 100 but also the panel lower cover PB and the polarizing film PF. In an embodiment, for example, the through-hole TH may penetrate the substrate SUB, the display layer DISL, the encapsulation layer ENC, and the sensor electrode layer SENL of the display panel 100. However, the present disclosure is not limited thereto, and the through-hole TH may penetrate the panel lower cover PB but may not penetrate the display panel 100 and the polarizing film PF in another embodiment. The cover window CW may be disposed to cover the through-hole TH.

The optical device OPD may be spaced apart from the display panel 100, the panel lower cover PB, and the polarizing film PF. The optical device OPD may be an optical sensor that senses light incident through the through-hole TH, such as a proximity sensor, an illuminance sensor, and a camera sensor.

FIG. 5 is a cross-sectional view illustrating an example of a display area of a display device according to an embodiment.

Referring to FIG. 5, the display device 10 according to an embodiment may include the display panel 100, the polarizing film PF, and the cover window CW.

In an embodiment, the display panel 100 may be an organic light emitting display panel having a light emitting element LEL including an organic light emitting layer 172. The display panel 100 may include a substrate SUB, a display layer DISL, an encapsulation layer ENC, and a sensor electrode layer SENL. The display layer DISL may include the thin film transistor layer TFTL including a plurality of thin film transistors and the light emitting element layer EML including a plurality of light emitting elements.

The substrate SUB may have a hard material. In an embodiment, for example, the substrate SUB may be made of glass. The substrate SUB may be formed of or include ultra thin glass (UTG) having a thickness of approximately 500 µm or less. Preferably, the thickness of the substrate SUB may be approximately 200 µm. In another embodiment, the substrate SUB may include a first substrate made of a hard material and a second substrate made of a polymer resin made of a flexible material.

The display layer DISL may include the thin film transistor layer TFTL including a plurality of thin film transistors and the light emitting element layer EML including a plurality of light emitting elements.

The thin film transistor layer TFTL may include a first buffer layer BF1, a thin film transistor TFT, a gate insulating layer 130, a first interlayer-insulating layer 141, a capacitor Cst, a second interlayer-insulating layer 142, a first data metal layer, a first organic layer 160, a second data metal layer, and a second organic layer 180.

The first buffer layer BF1 may be disposed on the substrate SUB. The first buffer layer BF1 may be formed of or include an inorganic material such as a silicon nitride layer, a silicon oxynitride layer, a silicon oxide layer, a titanium oxide layer and an aluminum oxide layer. Alternatively, the first buffer layer BF1 may be formed of multiple layers in which a plurality of layers of a silicon nitride layer, a silicon oxynitride layer, a silicon oxide layer, a titanium oxide layer and an aluminum oxide layer are alternately stacked.

An active layer including a channel region TCH, a source region TS, and a drain region TD of the thin film transistor TFT may be disposed on the first buffer layer BF1. The active layer may be formed of or include polycrystalline silicon, monocrystalline silicon, low-temperature polycrystalline silicon, amorphous silicon, or an oxide semiconductor material. When the active layer includes polycrystalline silicon or an oxide semiconductor material, the source region TS and the drain region TD of the active layer may be conductive regions doped with ions or impurities and having conductivity.

The gate insulating layer 130 may be disposed on the active layer of the thin film transistor TFT. The gate insulating layer 130 may be formed of or include an inorganic layer, for example, a silicon nitride layer, a silicon oxynitride layer, a silicon oxide layer, a titanium oxide layer, or an aluminum oxide layer.

A first gate metal layer including a gate electrode TG of the thin film transistor TFT, a first capacitor electrode CAE1 of the capacitor Cst, and scan lines may be disposed on the gate insulating layer 130. The gate electrode TG of the thin film transistor TFT may overlap the channel region TCH in the third direction (Z-axis direction). The first gate metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first interlayer-insulating layer 141 may be disposed on the first gate metal layer. The first interlayer-insulating layer 141 may be formed of or include an inorganic layer, for example, a silicon nitride layer, a silicon oxynitride layer, a silicon oxide layer, a titanium oxide layer, or an aluminum oxide layer. The first interlayer-insulating layer 141 may include a plurality of inorganic layers.

A second gate metal layer including the second capacitor electrode CAE2 of the capacitor Cst may be disposed on the first interlayer-insulating layer 141. The second capacitor electrode CAE2 may overlap the first capacitor electrode CAE1 in the third direction (Z-axis direction). Therefore, a capacitor Cst may be formed by the first capacitor electrode CAE1, the second capacitor electrode CAE2, and an inorganic insulating dielectric layer disposed therebetween to serve as a dielectric layer. The second gate metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second interlayer-insulating layer 142 may be disposed on the second gate metal layer. The second interlayer-insulating layer 142 may be formed of or include an inorganic layer, for example, a silicon nitride layer, a silicon oxynitride layer, a silicon oxide layer, a titanium oxide layer, or an aluminum oxide layer. The second interlayer-insulating layer 142 may include a plurality of inorganic layers.

The first data metal layer including a first connection electrode CE1 and the data lines may be disposed on the second interlayer-insulating layer 142. The first connection electrode CE1 may be connected to the drain region TD through a first contact hole CT1 penetrating the gate insulating layer 130, the first interlayer-insulating layer 141, and the second interlayer-insulating layer 142. The first data metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first organic layer 160 for flattening the stepped portion due to the thin film transistors TFT may be disposed on the first connection electrode CE1. The first organic layer 160 may be formed of or include an organic layer such as acryl resin, epoxy resin, phenolic resin, polyamide resin, polyimide resin and the like.

The second data metal layer including the second connection electrode CE2 may be disposed on the first organic layer 160. The second data metal layer may be connected to the first connection electrode CE1 through a second contact hole CT2 penetrating the first organic layer 160. The second data metal layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second organic layer 180 may be disposed on the second connection electrode CE2. The second organic layer 180 may be formed of or include an organic layer such as acryl resin, epoxy resin, phenolic resin, polyamide resin, polyimide resin and the like.

The second data metal layer including the second connection electrode CE2 and the second organic layer 180 may be omitted.

The light emitting element layer EML is disposed on the thin film transistor layer TFTL. The light emitting element layer EML may include light emitting elements LEL and a pixel defining layer 190.

Each of the light emitting elements LEL may include a pixel electrode 171, a light emitting layer 172, and a common electrode 173. Each of the emission areas EA is an area in which the pixel electrode 171, the light emitting layer 172, and the common electrode 173 are sequentially stacked such that the holes from the pixel electrode 171 and the electrons from the common electrode 173 are combined with each other to emit light. In this case, the pixel electrode 171 may be an anode electrode, and the common electrode 173 may be a cathode electrode.

A pixel electrode layer including the pixel electrode 171 may be disposed on the second organic layer 180. The pixel electrode 171 may be connected to the second connection electrode CE2 through a third contact hole CT3 penetrating the second organic layer 180. The pixel electrode layer may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

In a top emission structure that emits light toward the common electrode 173 with respect to the light emitting layer 172, the pixel electrode 171 may be formed of a single layer of molybdenum (Mo), titanium (Ti), copper (Cu), or aluminum (Al), or may be formed to have a stacked structure (Ti/Al/Ti) of aluminum and titanium, a stacked structure (ITO/AI/ITO) of aluminum and ITO, an APC alloy, or a stacked structure (ITO/APC/ITO) of APC alloy and ITO to increase the reflectivity. The APC alloy is an alloy of silver (Ag), palladium (Pd) and copper (Cu).

The pixel defining layer 190 serves to define emission areas EA of pixels. To this end, the pixel defining layer 190 may be formed to expose a partial region of the pixel electrode 171 on the second organic layer 180. The pixel defining layer 190 may cover an edge of the pixel electrode 171. The pixel defining layer 190 may be disposed in the third contact hole CT3. That is, the third contact hole CT3 may be filled with the pixel defining layer 190. The pixel defining layer 190 may be formed of or include an organic layer such as acryl resin, epoxy resin, phenolic resin, polyamide resin, polyimide resin and the like.

A spacer 191 may be disposed on the pixel defining layer 190. The spacer 191 may serve to support a mask during a process of manufacturing the light emitting layer 172. The spacer 191 may be formed of or include an organic layer such as acryl resin, epoxy resin, phenolic resin, polyamide resin, polyimide resin and the like.

The light emitting layer 172 is disposed on the pixel electrode 171. The light emitting layer 172 may include an organic material to emit light in a predetermined color. In an embodiment, for example, the light emitting layer 172 may include a hole transporting layer, an organic material layer, and an electron transporting layer. The organic material layer may include a host and a dopant. The organic material layer may include a material that emits predetermined light, and may be formed using a phosphorescent material or a fluorescent material.

The common electrode 173 is disposed on the light emitting layer 172. The common electrode 173 may be formed to cover the light emitting layer 172. The common electrode 173 may be a common layer formed in common on the emission areas EA. A capping layer may be disposed on the common electrode 173.

In the top emission structure, the common electrode 173 may be formed of or include a transparent conductive material ("TCO") such as ITO or IZO capable of transmitting light or a semi-transmissive conductive material such as magnesium (Mg), silver (Ag), or an alloy of magnesium (Mg) and silver (Ag). When the common electrode 173 is formed of or include a semi-transmissive conductive material, the light emission efficiency can be increased due to a micro-cavity effect.

The encapsulation layer ENC may be disposed on the light emitting element layer EML. The encapsulation layer ENC may include at least one inorganic layer TFE1 and TFE3 to prevent oxygen or moisture from permeating into the light emitting element layer EML. In addition, the encapsulation layer ENC may include at least one organic layer TFE2 to protect the light emitting element layer EML from foreign substances such as dust. In an embodiment, for example, the encapsulation layer ENC may include a first inorganic encapsulation layer TFE1, an organic encapsulation layer TFE2, and a second inorganic encapsulation layer TFE3.

The first inorganic encapsulation layer TFE1 may be disposed on the common electrode 173, the organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may be formed of a multilayer in which one or more inorganic layers of a silicon nitride layer, a silicon oxynitride layer, a silicon oxide layer, a titanium oxide layer and an aluminum oxide layer are alternately stacked. The encapsulation organic layer TFE2 may be an organic layer such as acryl resin, epoxy resin, phenolic resin, polyamide resin, polyimide resin or the like.

The sensor electrode layer SENL may be disposed on the encapsulation layer ENC. The sensor electrode layer SENL may include a second buffer layer BF2, a first connection portion BE1, a first sensor insulating layer TINS1, sensor electrodes TE and RE, and a second sensor insulating layer TINS2.

The second buffer layer BF2 may be disposed on the encapsulation layer ENC. The second buffer layer BF2 may include at least one inorganic layer. In an embodiment, for example, the second buffer layer BF2 may be formed of multiple layers in which one or more inorganic layers of a silicon nitride layer, a silicon oxynitride layer, a silicon oxide layer, a titanium oxide layer and an aluminum oxide layer are alternately stacked. The second buffer layer BF2 may be omitted.

The first connection portions BE1 may be disposed on the second buffer layer BF2. The first connection portions BE1 may be formed of a single layer containing molybdenum (Mo), titanium (Ti), copper (Cu), or aluminum (Al), or may be formed to have a stacked structure (Ti/AI/Ti) of aluminum and titanium, a stacked structure (ITO/AI/ITO) of aluminum and indium tin oxide ("ITO"), an Ag-Pd-Cu ("APC") alloy, or a stacked structure (ITO/APC/ITO) of APC alloy and ITO.

The first sensor insulating layer TINS1 may be disposed on the first connection portions BE1. The first sensor insulating layer TINS1 may be formed of or include an inorganic layer, for example, a silicon nitride layer, a silicon oxynitride layer, a silicon oxide layer, a titanium oxide layer, or an aluminum oxide layer.

The sensor electrodes, that is, the driving electrodes TE and the sensing electrodes RE may be disposed on the first sensor insulating layer TNIS1. In addition, dummy patterns may be disposed on the first sensor insulating layer TNIS1. The driving electrodes TE, the sensing electrodes RE, and the dummy patterns do not overlap the emission areas in a plan view. The driving electrodes TE, the sensing electrodes RE, and the dummy patterns may be formed of a single layer containing molybdenum (Mo), titanium (Ti), copper (Cu), or aluminum (Al), or may be formed to have a stacked structure (Ti/AI/Ti) of aluminum and titanium, a stacked structure (ITO/AI/ITO) of aluminum and indium tin oxide (ITO), an Ag-Pd-Cu (APC) alloy, or a stacked structure (ITO/APC/ITO) of APC alloy and ITO.

The second sensor insulating layer TINS2 may be disposed on the driving electrodes TE, the sensing electrodes RE, and the dummy patterns. The second sensor insulating layer TINS2 may include at least one of an inorganic layer or an organic layer. The inorganic layer may be a silicon nitride layer, a silicon oxynitride layer, a silicon oxide layer, a titanium oxide layer, or an aluminum oxide layer. The organic layer may include acryl resin, epoxy resin, phenolic resin, polyamide resin, or polyimide resin.

The polarizing film PF may be disposed on the sensor electrode layer SENL. The polarizing film PF may be disposed on the display panel 100 to reduce reflection of external light. The polarizing film PF may include a first base member, a linear polarization plate, a phase retardation film such as a quarter-wave plate (λ/4 plate), and a second base member. The first base member, the phase retardation film, the linear polarization plate, and the second base member of the polarizing film PF may be sequentially stacked on the display panel 100.

The cover window CW may be disposed on the polarizing film PF. The cover window CW may be attached on the polarizing film PF by a transparent adhesive member such as an optically clear adhesive (OCA) film.

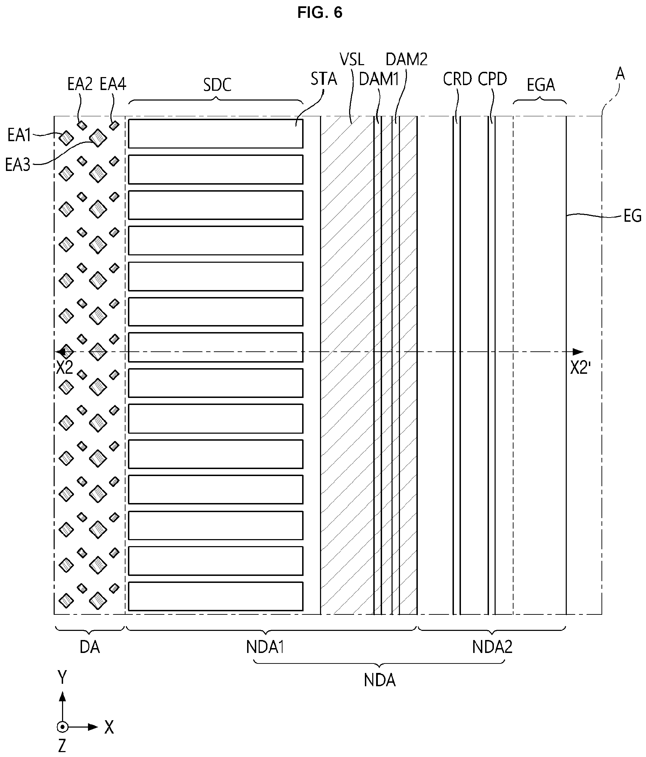

FIG. 6 is an enlarged view of area A of FIG. 2.

Referring to FIG. 6 in addition to FIG. 5, the display area DA may include a plurality of emission areas EA1, EA2, EA3, and EA4. The plurality of emission areas EA1, EA2, EA3, and EA4 may include the first emission area EA1 emitting light of a first color, the second emission area EA2 and the fourth emission area EA4 emitting light of a second color, and the third emission area EA3 emitting light of a third color. In an embodiment, for example, light of the first color may be light in a red wavelength band of approximately 600 nm to 750 nm, light of the second color may be light in a green wavelength band of approximately 480 nm to 560 nm, and light of the third color may be light in a blue wavelength band of approximately 370 nm to 460 nm, but embodiments of the present specification are not limited thereto.

Although FIG. 6 illustrates that the second emission area EA2 and the fourth emission area EA4 emit light of the same color, that is, light of the second color, the embodiment of the present specification is not limited thereto. The second emission area EA2 and the fourth emission area EA4 may emit light of different colors. In an embodiment, for example, the second emission area EA2 may emit light of the second color, and the fourth emission area EA4 may emit light of a fourth color.

In addition, in FIG. 6, although it is illustrated that each of the first emission areas EA1, the second emission areas EA2, the third emission areas EA3, and the fourth emission areas EA4 has a rectangular planar shape, the embodiment of the present specification is not limited thereto. Each of the first emission areas EA1, the second emission areas EA2, the third emission areas EA3, and the fourth emission areas EA4 may have a polygonal shape other than a quadrilateral shape, a circular shape, or an elliptical shape in a plan view.

In some embodiments, the third emission area EA3 may have the largest area, and the second emission area EA2 and the fourth emission area EA4 may have the smallest areas. The area of the second emission area EA2 and the area of the fourth emission area EA4 may be the same, but are not limited thereto.

The second emission areas EA2 and the fourth emission areas EA4 may be alternately disposed in the first direction (X-axis direction). The second emission areas EA2 may be disposed in the second direction (Y-axis direction). The fourth emission areas EA4 may be disposed in the second direction (Y-axis direction).

The first emission areas EA1 and the third emission areas EA3 may be alternately disposed in the first direction (X-axis direction). The first emission areas EA1 may be disposed in the second direction (Y-axis direction). The third emission areas EA3 may be disposed in the second direction (Y-axis direction). Each of the first emission areas EA1 and the third emission areas EA3 may have a square planar shape, but the embodiment of the present specification is not limited thereto.

The non-display area NDA includes a first non-display area NDA1 and a second non-display area NDA2. The first non-display area NDA1 may be an area in which structures for driving pixels of the display area DA are disposed. The second non-display area NDA2 may be disposed outside the first non-display area NDA1. The second non-display area NDA2 may be an area outside the non-display area NDA. In addition, the second non-display area NDA2 may be an area outside the display panel 100.

The first non-display area NDA1 may include a scan driving circuit unit SDC, a first power line VSL, a first dam DAM1, and a second dam DAM2.

The scan driving circuit unit SDC may include a plurality of stages STA. The plurality of stages STA may be connected to scan lines of the display area DA extending in the first direction (X-axis direction), respectively. That is, the plurality of stages STA may be connected one-to-one to the scan lines of the display area DA extending in the first direction (X-axis direction). The plurality of stages STA may sequentially apply scan signals to a plurality of scan lines.

The first power line VSL may be disposed outside the scan driving circuit unit SDC. That is, the first power line VSL may be disposed closer to an edge EG of the display panel 100 than the scan driving circuit unit SDC. The first power line VSL may extend in the second direction (Y-axis direction) in the non-display area NDA on the left side of the display panel 100.

The first power line VSL may be electrically connected to the common electrode 173, so that the common electrode 173 may be supplied with the first source voltage from the first power line VSL.

The first dam DAM1 and the second dam DAM2 may be structures for preventing the overflow of the encapsulation organic layer TFE2 of the encapsulation layer ENC into the edge EG of the display panel 100.

The first dam DAM1 may be disposed to surround the display area DA, and the second dam DAM2 may be disposed to surround the first dam DAM1. In an embodiment, for example, as illustrated in FIG. 6, the first dam DAM1 and the second dam DAM2 may extend in the second direction (Y-axis direction) in the non-display area NDA on the right side of the display panel 100. The second dam DAM2 may be disposed outside the first dam DAM1. Although not illustrated, the first dam DAM1 and the second dam DAM2 may also be disposed in non-display areas NDA on the upper side, lower side, and left side of the display panel 100. The first dam DAM1 and the second dam DAM2 may extend in the second direction (Y-axis direction) in the non-display area NDA on the left side of the display panel 100, and may extend in the first direction (X-axis direction) in the non-display areas NDA on the upper side and the lower side of the display panel 100.

The first dam DAM1 may be disposed closer to the scan driving circuit unit SDC than the second dam DAM2, and the second dam DAM2 may be disposed closer to the edge EG of the display panel 100 than the first dam DAM1.

Although FIG. 6 illustrates that the first dam DAM1 and the second dam DAM2 are disposed on the first power line VSL, the present disclosure is not limited thereto. For another example, either one of the first dam DAM1 and the second dam DAM2 may not be disposed on the first power line VSL. Alternatively, neither the first dam DAM 1 nor the second dam DAM2 may be disposed on the first power line VSL. In this case, the first dam DAM1 and the second dam DAM2 may be disposed outside the first power line VSL.

In addition, although FIG. 6 illustrates that the display panel 100 according to an embodiment includes two dams DAM1 and DAM2, the embodiment of the present specification is not limited thereto. That is, the display panel 100 according to an embodiment may include three or more dams.

The second non-display area NDA2 may include a crack dam CRD, a protection dam CPD, and an edge area EGA.

The crack dam CRD may be a structure for preventing cracks of the inorganic layers of the encapsulation layer ENC from propagating in a process of cutting the substrate SUB during the manufacturing process of the display device 10. The crack dam CRD may be disposed in the second non-display area NDA2 and may be disposed outside the first dam DAM1 and the second dam DAM2. In an embodiment, for example, the crack dam CRD may be disposed closer to the edge EG of the display panel 100 than the first dam DAM1 and the second dam DAM2.

The crack dam CRD may be disposed along left, upper, and right edges of the display panel 100. In an embodiment, for example, as illustrated in FIG. 6, the crack dam CRD may extend in the second direction (Y-axis direction) in the non-display area NDA on the right side of the display panel 100. Although not illustrated, the crack dam CRD may also be disposed in the non-display area NDA on the upper side and the left side of the display panel 100. The crack dam CRD may extend in the second direction (Y-axis direction) in the non-display area NDA on the left side of the display panel 100, and may extend in the first direction (X-axis direction) in the non-display area NDA on the upper side of the display panel 100. The crack dam CRD may not be disposed on the lower edge of the display panel 100. However, the present disclosure is not limited thereto, and in another embodiment, the crack dam CRD may also be disposed in the non-display area NDA below the display panel 100, and in this case, the crack dam CRD may extend in the first direction (X-axis direction).

The protection dam CPD may be a structure for preventing an etchant from permeating toward the display area DA during the process of etching the substrate SUB to reduce the thickness of the substrate SUB during the manufacturing process of the display device 10. The protection dam CPD may be disposed in the second non-display area NDA2 and may be disposed outside the crack dam CRD. In an embodiment, for example, the protection dam CPD may be disposed closer to the edge EG of the display panel 100 than the crack dam CRD.

The protection dam CPD may be disposed along left, upper, and right edges of the display panel 100. In an embodiment, for example, as illustrated in FIG. 6, the protection dam CPD may extend in the second direction (Y-axis direction) in the non-display area NDA on the right side of the display panel 100. Although not illustrated, the protection dam CPD may also be disposed in the non-display areas NDA on the upper side and the left side of the display panel 100. The protection dam CPD may extend in the second direction (Y-axis direction) in the non-display area NDA on the left side of the display panel 100, and may extend in the first direction (X-axis direction) in the non-display area NDA on the upper side of the display panel 100. The protection dam CPD may not be disposed on the lower edge of the display panel 100. However, the present disclosure is not limited thereto, and in another embodiment, the protection dam CPD may also be disposed in the non-display area NDA below the display panel 100, and in this case, the protection dam CPD may extend in the first direction (X-axis direction).

The edge area EGA may be disposed along the edge EG of the display panel 100. The edge area EGA may be an area in which processing traces generated in a process of cutting the substrate SUB are generated.

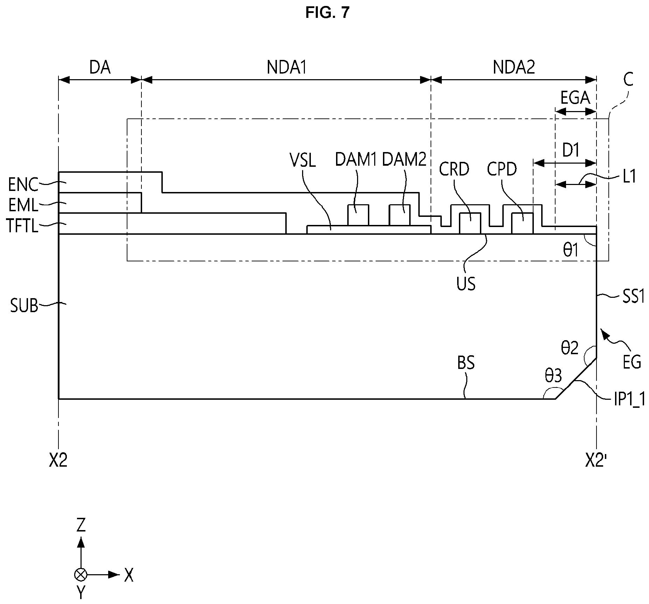

FIG. 7 is a cross-sectional view taken along line X2-X2' of FIG. 6.

Referring to FIG. 7, when the substrate SUB is cut by spraying the etchant after laser irradiation by a laser processing device, the edge area EGA may be an area in which processing traces are formed on a top surface US of the substrate SUB by the etchant. A width L1 of the edge area EGA may be within approximately 30 µm.

The edge area EGA may include a first inclined surface IP1_1 formed by spraying the etchant after laser irradiation. An angle θ1 between the side surface SS1 and the top surface US may be within 90 degrees. That is, an angle between the side surface SS1 and the top surface US may be substantially close to the right angle. An angle θ2 between the side surface SS1 and the first inclined surface IP1_1 and an angle θ3 between the first inclined surface IP1_1 and a bottom surface BS may be obtuse angles. The processing traces formed on the top surface US of the substrate SUB may overlap the first inclined surface IP1_1 in the third direction (Z-axis direction).

However, the present disclosure is not limited thereto, and in some embodiments, the first inclined surface IP1_1 may be omitted. Depending on the manufacturing process of the display device 1, the first inclined surface IP1_1 may not be formed, and only the side surface SS1 may be disposed between the top surface US and the bottom surface BS. In addition, the side surface SS1 may have a curved shape as well as a flat surface. Hereinafter, for simplicity of description, a case including the first inclined surface IP1_1 will be described as an example.

While the processing traces are traces formed by the permeation of the etchant permeating between the acid-resistant film and the top surface of the substrate SUB in the manufacturing process of the display device 10, the first inclined surface IP1_1 is the inclined surface directly formed by the etchant, so that the width of the edge area EGA in which the processing traces are formed may be smaller than the width of the first inclined surface IP1_1. The width of the edge area EGA refers to the length of the edge area EGA in the first direction (X-axis direction) or the length thereof in the second direction (Y-axis direction). The width of the first inclined surface IP1_1 refers to the length of the first inclined surface IP1_1 in the first direction (X-axis direction) or the length thereof in the second direction (Y-axis direction).

The protection dam CPD may be a structure for preventing an etchant from permeating toward the display area DA during the process of etching the substrate SUB to reduce the thickness of the substrate SUB during the manufacturing process of the display device 10. The protection dam CPD may be an outermost structure disposed on the outermost side of the display panel 100.

When the substrate SUB is cut by spraying the etchant after laser irradiation, a distance D1 between the protection dam CPD and the edge EG of the display panel 100 may be greater than the one-side tolerance of the laser. In an embodiment, for example, when the one-side tolerance of the laser is 50 µm, the distance D1 between the protection dam CPD and the edge EG of the display panel 100 may be 50 µm or more. The distance D1 between the protection dam CPD and the edge EG of the display panel 100 may be a maximum of 150 µm or less.

The distance between the protection dam CPD and the edge area EGA may be preferably approximately 30 µm or less. In some embodiments, a minimum value of the distance between the protection dam CPD and the edge area EGA may be 0 µm. That is, the protection dam CPD and the edge area EGA may overlap in a plan view. In this case, the processing traces formed by the etchant may overlap the protection dam CPD in a plan view.

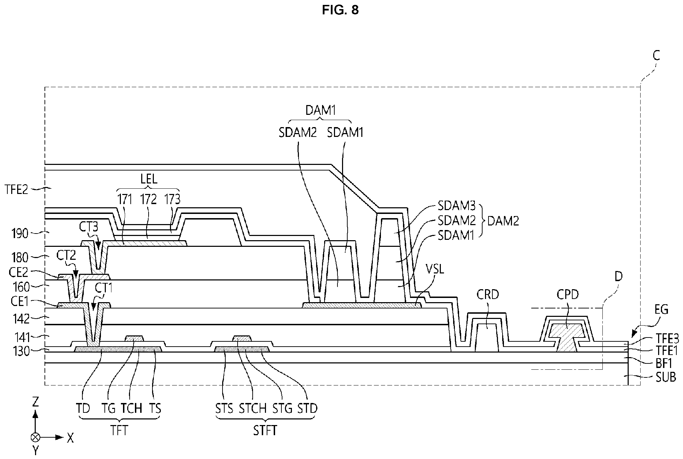

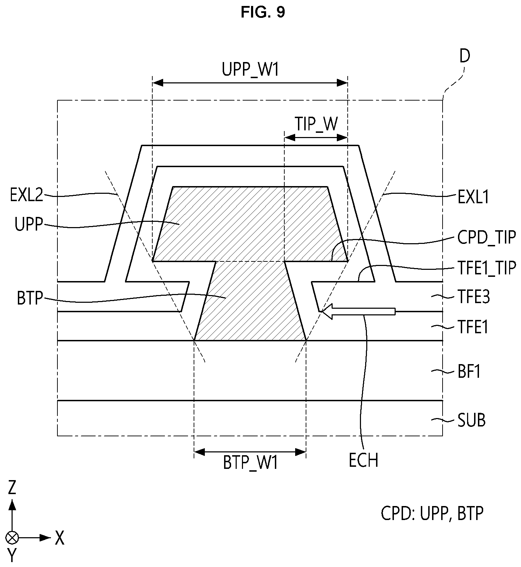

When the etchant permeates from the edge EG of the display panel 100 and reaches the protection dam CPD, the protection dam CPD and the edge area EGA may overlap in a plan view. The display device 10 according to the present embodiment may include the protection dam CPD, and thus may prevent the etchant from permeating from the edge EG of the display panel 100 toward the display area DA in the manufacturing process of the display device 10. A description of the protection dam CPD will be given later with reference to FIGS. 8 and 9.

The crack dam CRD may be a structure for preventing cracks of the inorganic layers of the encapsulation layer ENC from propagating in a process of cutting the substrate SUB during the manufacturing process of the display device 10. The crack dam CRD may be disposed inside the display panel 100 as compared with the protection dam CPD. In an embodiment, for example, the crack dam CRD may be disposed closer to the display area DA than the protection dam CPD, and may be disposed further away from the edge EG of the display panel 100.

When the substrate SUB of the display panel 100 is cut by spraying the etchant after laser irradiation during the manufacturing process of the display device 10, the side surface SS1 and the first inclined surface IP1_1 of the display panel 100 may be etched by the etchant. In this case, the roughness of the side surface SS1 and the first inclined surface IP1_1 of the display panel 100 may be approximately 0.5 µm or less. In the present specification, roughness may mean a maximum height difference between peaks and valleys of a surface.

When the substrate SUB of the display panel 100 is cut by spraying the etchant after laser irradiation, the roughness of the side surface SS1 and the first inclined surface IP1_1 of the display panel 100 may be smaller than the roughness of the cut surface of the display panel 100 when the polishing process is performed after cutting the substrate SUB with a cutting member.

When the substrate SUB of the display panel 100 is cut by spraying the etchant after laser irradiation, the minimum distance from the protection dam CPD to the edge EG of the display panel 100 may be reduced. Accordingly, when the substrate SUB of the display panel 100 is cut by spraying the etchant after laser irradiation, the width of the second non-display area NDA2 may be greatly reduced. That is, the width of the non-display area NDA may be minimized.

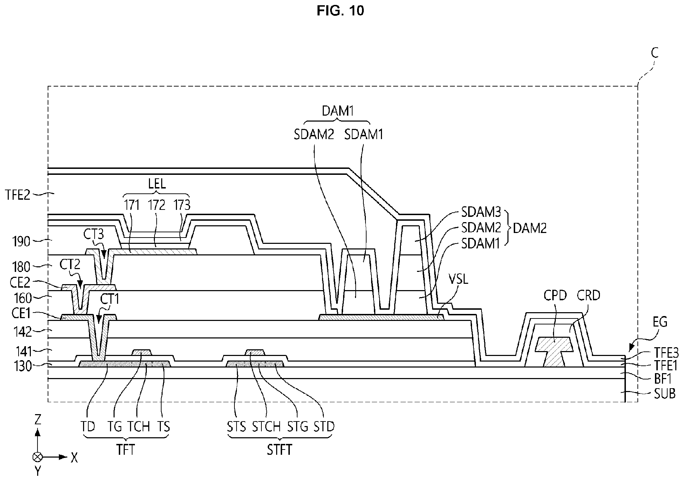

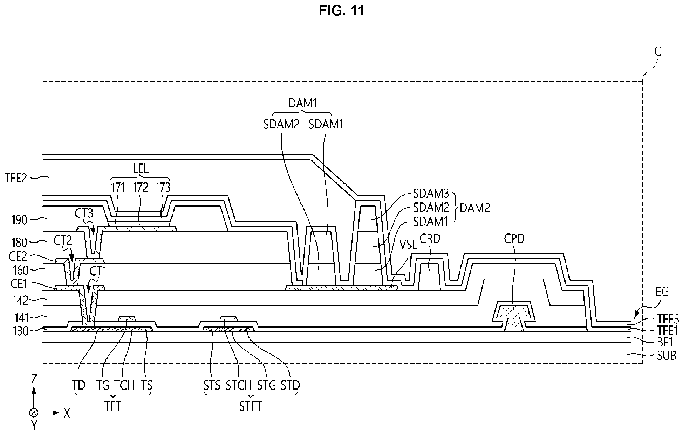

FIG. 8 is an enlarged view of area C of FIG. 7. FIG. 9 is an enlarged view of area D of FIG. 8. FIG. 10 is a cross-sectional view illustrating a part of a display device according to another embodiment. FIG. 11 is a cross-sectional view illustrating a part of a display device according to still another embodiment.

Referring to FIGS. 8 to 11, the first power line VSL may include the same material as the first data metal layer including the first connection electrode CE1 and the data lines, and may be disposed on the same layer. The first power line VSL may be disposed on the second interlayer-insulating layer 142. The first power line VSL may be formed as a single layer or multiple layers made of any one of molybdenum (Mo), aluminum (Al), chromium (Cr), gold (Au), titanium (Ti), nickel (Ni), neodymium (Nd), and copper (Cu) or an alloy thereof.

The first dam DAM1 and the second dam DAM2 may be disposed on the first power line VSL. The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 and the first organic layer 160 may include the same material, and may be disposed on the same layer. The second sub-dam SDAM2 and the second organic layer 180 may include the same material, and may be disposed on the same layer. The third sub-dam SDAM3 may include the same material as the pixel defining layer 190 and may be disposed on the same layer.

The height of the first dam DAM1 may be lower than the height of the second dam DAM2, but the embodiment of the present specification is not limited thereto. The height of the first dam DAM1 may be substantially the same as the height of the second dam DAM2 or may be higher than the height of the second dam DAM2 in another embodiment.

The common electrode 173 may be connected to the first power line VSL exposed without being covered by the first organic layer 160, the second organic layer 180, and the first dam DAM1. Accordingly, the common electrode 173 may be supplied with the first source voltage of the first power line VSL.

The first encapsulation inorganic layer TFE1 may cover the first dam DAM1, the second dam DAM2, the crack dam CRD, and the protection dam CPD in the non-display area NDA. However, the present disclosure is not limited thereto, and in some embodiments, the first encapsulation inorganic layer TFE1 may not cover at least one of the second dam DAM2, the crack dam CRD, or the protection dam CPD.

In an embodiment, the side of the first encapsulation inorganic layer TFE1 may be disposed to be aligned with and coincide with the side edge of the substrate SUB at the edge EG of the display panel 100, but is not limited thereto.

The encapsulation organic layer TFE2 may be disposed to cover the top surface of the first dam DAM1 without covering the top surface of the second dam DAM2. However, the embodiments of the present specification are not limited thereto. The encapsulation organic layer TFE2 may not cover both the top surface of the first dam DAM1 and the top surface of the second dam DAM2. The encapsulation organic layer TFE2 may not overflow to the edge EG of the display panel 100 due to the first dam DAM1 and the second dam DAM2.

The second encapsulation inorganic layer TFE3 may cover the first dam DAM1, the second dam DAM2, the crack dam CRD, and the protection dam CPD in the non-display area NDA. However, the present disclosure is not limited thereto, and in some embodiments, the second encapsulation inorganic layer TFE3 may not cover at least one of the second dam DAM2, the crack dam CRD, or the protection dam CPD.

In an embodiment, the side of the second encapsulation inorganic layer TFE3 may be disposed to be aligned with and coincide with the side edge of the substrate SUB at the edge EG of the display panel 100, but is not limited thereto.

An inorganic encapsulation area in which the first encapsulation inorganic layer TFE1 and the second encapsulation inorganic layer TFE3 are in contact with each other may be formed from the second dam DAM2 to the edge EG of the display panel 100. The inorganic encapsulation area may be disposed to surround the second dam DAM2.

In FIG. 8, a scan thin film transistor STFT of the scan driving circuit unit SDC is exemplified. Since the scan thin film transistor STFT is substantially the same as the thin film transistor TFT described in conjunction with FIG. 5, a description of the scan thin film transistor STFT will be omitted.

The crack dam CRD may include the same material as the first organic layer 160. The crack dam CRD may be disposed on the first buffer layer BF1. The crack dam CRD may be formed of or include an organic layer such as acryl resin, epoxy resin, phenolic resin, polyamide resin, polyimide resin and the like.

Although FIG. 8 illustrates that the crack dam CRD includes one organic film layer, the embodiment of the present specification is not limited thereto. For another example, the crack dam CRD may further include another organic film layer including the same material as the second organic layer 180. Alternatively, the crack dam CRD may further include another organic film layer including the same material as the pixel defining layer 190. Alternatively, the crack dam CRD may further include another organic film layer including the same material as the spacer 191 (see FIG. 5).

The protection dam CPD may function as a passivation layer or a sacrificial layer having acid resistance to the etchant ECH.

In some embodiments, when the protection dam CPD functions as a passivation layer having acid resistance, the protection dam CPD may physically prevent the etchant ECH from permeating. When the protection dam CPD functions as a passivation layer having acid resistance, the protection dam CPD may include an organic layer or an inorganic layer.

Specifically, when the protection dam CPD includes an organic layer, the protection dam CPD may include at least one of polyimide, polyamide, polyethylene, polypropylene, polyvinyl chloride ("PVC"), polyester, polyolefin, carbon fiber, or carbon fiber-reinforced epoxy resin. In addition, when the protection dam CPD includes an organic layer, it may include at least one of fluoropolymer such as polyvinylidene fluoride or polytetrafluoroethylene ("PTFE").

When the protection dam CPD includes an inorganic layer, the protection dam CPD may include silicon nitride (SiNx).

In some embodiments, when the protection dam CPD functions as a sacrificial layer, the protection dam CPD may include a metal material that may be oxidized by the etchant ECH. In an embodiment, for example, the protection dam CPD may include at least one of vanadium, niobium, tantalum, chromium, molybdenum, tungsten, nickel, titanium, palladium, platinum, copper, silver, gold, aluminum, titanium/tungsten (Ti/W), nickel/chromium (Ni/Cr), titanium nitride (TiN), copper/zeolite (Cu/Z), carbon steel, chromium-nickel-molybdenum steel, or a nickel-chromium-iron alloy.

In the display device 10 according to the present embodiment, when the protection dam CPD functions as a sacrificial layer, the protection dam CPD may meet with the etchant ECH to oxidize the metal material to form a barrier layer. Although not illustrated, the barrier layer may be formed by the etchant ECH permeating on the side of the edge EG of the display panel 100, and thus may be disposed on the side surface of the protection dam CPD adjacent to the edge EG of the display panel 100. Accordingly, the barrier layer may block oxygen and moisture that may permeate from the edge EG of the display panel 100.

As illustrated in FIG. 9, the protection dam CPD may include an upper portion UPP and a lower portion BTP. The upper portion UPP may be disposed on the lower portion BTP. In the present specification, the upper portion UPP and the lower portion BTP are separately described for simplicity of description, but the two components may be physically and integrally formed with each other as one component. However, the present disclosure is not limited thereto, and may be separate components each formed through a separate process in another embodiment.

Each of the upper portion UPP and the lower portion BTP of the protection dam CPD may have a normal tapered trapezoidal shape in which the width of the top surface is narrower than the width of the bottom surface in cross-sectional view, but the present disclosure is not limited thereto. For another example, at least one of the upper portion UPP or the lower portion BTP of the protection dam CPD may each have a reverse tapered trapezoidal shape in which the width of the top surface is wider than the width of the bottom surface in cross-sectional view. In addition, each of the upper portion UPP and the lower portion BTP of the protection dam CPD may have a polygonal shape such as a rectangular shape or a hexagonal shape, or a shape including a curved line such as a semicircle in cross-sectional view.

In some embodiments, in the protection dam CPD, a width UPP_W1 of the upper portion UPP in the X-axis direction may be greater than a width BTP_W1 (e.g., maximum width) of the lower portion BTP in the X-axis direction. In an embodiment, for example, a first extension line EXL1 (that is, a virtual line) connecting one lower end of the upper portion UPP to one lower end of the lower portion BTP, and a second extension line EXL2 connecting an opposite lower end of the upper portion UPP to an opposite lower end of the lower portion BTP may form a reverse tapered shape.

An end of the upper portion UPP may protrude more than an end of the lower portion BTP. Accordingly, the protection dam CPD may include a protection tip CPT_TIP. The protection dam CPD may include the protection tip CPT_TIP, so that the display device 10 according to the present embodiment may prevent the etchant ECH from permeating from the edge EG of the display panel 100 toward the display area DA in the manufacturing process of the display device 10.

Specifically, a tip may be disposed on an upper layer directly disposed on the protection dam CPD by the protection tip CPT_TIP of the protection dam CPD. In an embodiment, for example, the first encapsulation inorganic layer TFE1 disposed directly on the protection dam CPD may include an upper layer tip TFE1_TIP. When a length TIP_W of the protection tip CPT_TIP is below a certain level in consideration of the step coverage of the first encapsulation inorganic layer TFE1, which is the upper layer, the first encapsulation inorganic layer TFE1, which is the upper layer, may be connected without disconnection. Accordingly, the first encapsulation inorganic layer TFE1 may include the upper layer tip TFE1_TIP. Step coverage refers to the ratio of the degree of thin film coated on an inclined portion to the degree of thin film coated on a flat portion.

In the manufacturing process of the display device 10, when the etchant ECH permeates from the edge EG of the display panel 100 toward the display area DA, the etchant ECH needs to pass through the protection tip CPD_TIP of the protection dam CPD and/or the upper layer tip TFE1_TIP of the first encapsulation inorganic layer TFE1 that is the upper layer. Due to the tip structure, the movement path of the etchant ECH becomes longer, and needs to move further in the upward direction and in the opposite direction to the permeation direction. Therefore, it is possible to effectively prevent the etchant ECH from permeating.

As illustrated in FIG. 10, in another embodiment, the crack dam CRD may overlap the protection dam CPD in a plan view. The crack dam CRD may be disposed on the protection dam CPD. The crack dam CRD may completely cover the top surface and the side surface of the protection dam CPD. In this case, since the separation distance between the crack dam CRD and the protection dam CPD may be reduced, the width of the non-display area NDA may be further reduced.

As illustrated in FIG. 11, in still another embodiment, at least one of the gate insulating layer 130, the first interlayer-insulating layer 141, the second interlayer-insulating layer 142, the first encapsulation inorganic layer TFE1, or the second encapsulation inorganic layer TFE3 may be disposed on the protection dam CPD. That is, the upper layer disposed directly on the protection dam CPD may be at least one of the gate insulating layer 130, the first interlayer-insulating layer 141, the second interlayer-insulating layer 142, the first encapsulation inorganic layer TFE1, or the second encapsulation inorganic layer TFE3.

As described above, in the display device 10 according to the present embodiment, the upper layer disposed directly on the protection dam CPD may be at least one of the gate insulating layer 130, the first interlayer-insulating layer 141, the second interlayer-insulating layer 142, the first organic layer 160, the second organic layer 180, the first encapsulation inorganic layer TFE1, or the second encapsulation inorganic layer TFE3.

On the drawing, the protection dam CPD is illustrated as one, but is not limited thereto. For another example, according to the permeation degree of the etchant, the protection dam CPD may be provided in plurality between at least two layers of the gate insulating layer 130, the first interlayer-insulating layer 141, the second interlayer-insulating layer 142, the first organic layer 160, the second organic layer 180, the first encapsulation inorganic layer TFE1, or the second encapsulation inorganic layer TFE3. In addition, the protection dam CPD may be disposed in a horizontal direction and provided in plurality.

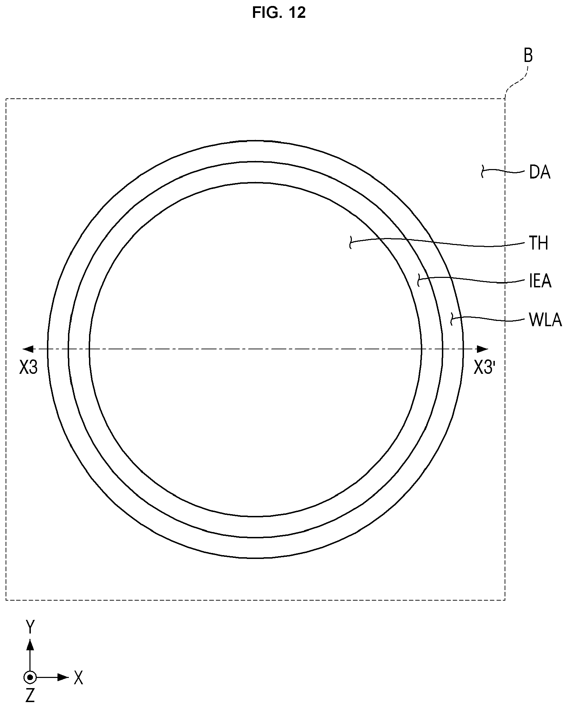

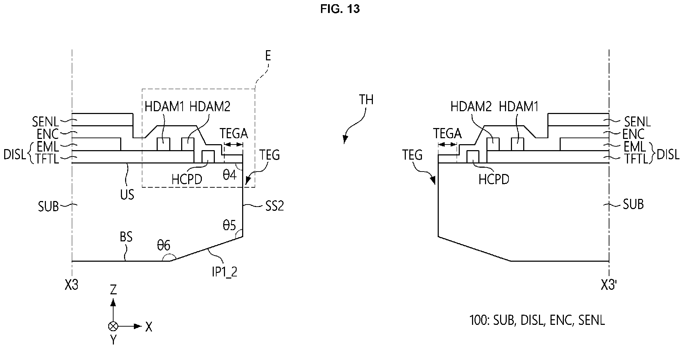

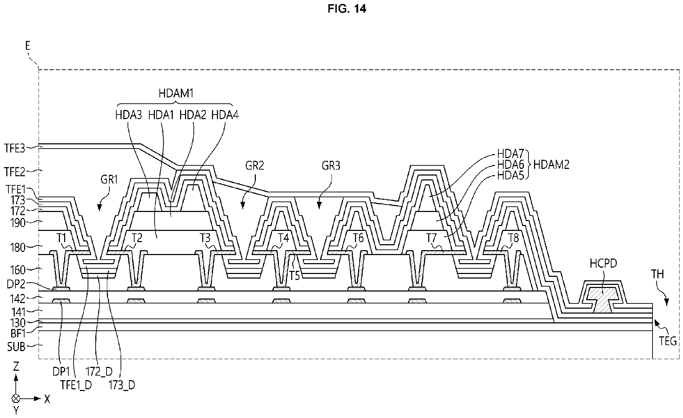

FIG. 12 is an enlarged view of area B of FIG. 2. FIG. 13 is a cross-sectional view taken along line X3-X3' in FIG. 12. FIG. 14 is an enlarged view of area E of FIG. 13.

Referring to FIGS. 12 to 14, the display panel 100 according to an embodiment includes an inorganic encapsulation area IEA surrounding the through-hole TH and a wiring area WLA surrounding the inorganic encapsulation area IEA.

The first encapsulation inorganic layer TFE1 and the second encapsulation inorganic layer TFE3 of the encapsulation layer ENC may be in contact with each other, so that the inorganic encapsulation area IEA may be a layer for preventing oxygen or moisture from permeating into the light emitting element layer EML of the display layer DISL due to the through-hole TH.

The inorganic encapsulation area lEA may include at least one dam, at least one tip, and at least one groove. In an embodiment, for example, as illustrated in FIG. 14, the inorganic encapsulation area lEA may include a first hole dam HDAM1, a second hole dam HDAM2, first to eighth tips T1 to T8, and first to third grooves GR1 to GR3.

The first tip T1 and the second tip T2 may be disposed closer to the wiring area WLA than the first hole dam HDAM1. The first tip T1 may be disposed closer to the wiring area WLA than the second tip T2. The second tip T2 may be disposed between the first tip T1 and the first hole dam HDAM1.

The third tip T3, the fourth tip T4, the fifth tip T5, and the sixth tip T6 may be disposed between the first hole dam HDAM1 and the second hole dam HDAM2. At least a part of the third tip T3 may overlap the first hole dam HDAM1 in the third direction (Z-axis direction).

The seventh tip T7 and the eighth tip T8 may be disposed closer to the through-hole TH than the second hole dam HDAM2. At least a part of the seventh tip T7 may overlap the second hole dam HDAM2 in the third direction (Z-axis direction). The eighth tip T8 may be disposed between the second hole dam HDAM2 and the through-hole TH.

The first groove GR1 may be disposed between the first tip T1 and the second tip T2. The second groove GR2 may be disposed between the third tip T3 and the fourth tip T4. The third groove GR3 may be disposed between the fifth tip T5 and the sixth tip T6.

The wiring area WLA may be an area in which bypass lines due to the through-hole TH are disposed. Some of the bypass lines may be connected to data lines, and some others of the bypass lines may be connected to a second power line to which a second source voltage higher than the first source voltage is applied. Yet some others of the bypass lines may be connected to the scan lines. The wiring area WLA may be surrounded by the display area DA.

FIG. 13 illustrates a cross section of the edge TEG of the through-hole TH formed when the substrate SUB is cut by spraying the etchant after laser irradiation by the laser processing device in the manufacturing process of the display device 10.

As illustrated in FIG. 13, when the substrate SUB is cut by spraying the etchant after laser irradiation by the laser processing device in the manufacturing process of the display device 10, a through-hole edge area TEGA may be an area in which processing traces are formed on the top surface US of the substrate SUB. A width of the through-hole edge area TEGA may be within approximately 30 µm.

The through-hole edge area TEGA may include a second inclined surface IP1_2 formed by spraying the etchant after laser irradiation. An angle θ4 between a side surface SS2 of the edge TEG of the through-hole TH and the top surface US may be within 90 degrees. That is, an angle between the side surface SS2 of the edge TEG of the through-hole TH and the top surface US may be substantially close to the right angle. An angle θ5 between the side surface SS2 of the edge TEG of the through-hole TH and the second inclined surface IP1_2 and an angle θ6 between the second inclined surface IP1_2 and the bottom surface BS may be obtuse angles. The processing traces formed on the top surface US of the substrate SUB may overlap the second inclined surface IP1_2 in the third direction (Z-axis direction).

While the processing traces are traces formed by the permeation of the etchant permeating between the acid-resistant film and the top surface of the substrate SUB in the manufacturing process of the display device 10, the second inclined surface IP1_2 is the inclined surface directly formed by the etchant, so that the width of the through-hole edge area TEGA in which the processing traces are formed may be smaller than the width of the first inclined surface IP1_1. The width of the through-hole edge area TEGA refers to the length of the through-hole edge area TEGA in the first direction (X-axis direction) or the length thereof in the second direction (Y-axis direction). The width of the second inclined surface IP1_2 refers to the length of the second inclined surface IP1_2 in the first direction (X-axis direction) or the length thereof in the second direction (Y-axis direction). In an embodiment, the length of the first inclined surface I P1_1 may be shorter than the length of the second inclined surface I P1_2.

The angle θ5 between the side surface SS2 of the edge TEG of the through-hole TH and the second inclined surface IP1_2 and the angle θ6 between the second inclined surface I P1_2 and the bottom surface BS may vary according to the depth of the laser irradiation area formed by the laser when the substrate SUB of the display panel 100 is cut by spraying the etchant after laser irradiation. The depth of the laser irradiation area formed by the laser to perform cutting along the edge EG (see FIG. 7 or the like) of the display panel 100 may be different from the depth of the laser irradiation area formed by the laser to perform cutting along the edge TEG of the through-hole TH.

In an embodiment, for example, the angle θ5 between the side surface SS2 of the edge TEG of the through-hole TH illustrated in FIG. 13 and the second inclined surface IP1_2 may be smaller than the angle θ2 between the side surface SS1 and the first inclined surface IP1_1 illustrated in FIG. 7. The angle θ6 between the second inclined surface IP1_2 and the bottom surface BS illustrated in FIG. 13 may be greater than the angle θ3 between the first inclined surface IP1_1 and the bottom surface BS illustrated in FIG. 7.

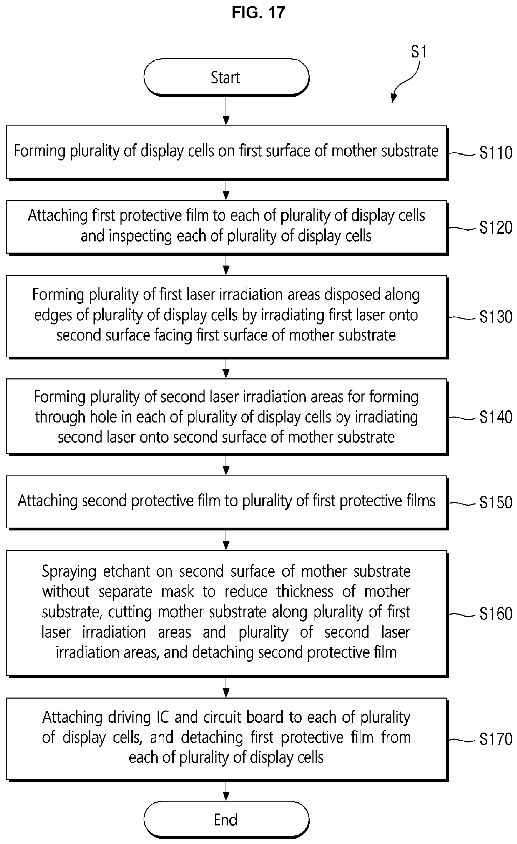

The depth of the laser irradiation area formed by the laser to perform cutting along the edge EG of the display panel 100 and the depth of the laser irradiation area formed by the laser to perform cutting along the edge TEG of the through-hole TH will be described later in a manufacturing method S1 (see FIG. 17) of the display device according to an embodiment with reference to FIG. 17 or the like.

As illustrated in FIG. 14, a first dummy pattern DP1 may include the same material as the second gate metal layer including the second capacitor electrode CAE2 of the capacitor Cst and may be disposed on the same layer. In an embodiment, for example, the first dummy pattern DP1 may be disposed on the first interlayer-insulating layer 141. The first dummy pattern DP1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second dummy pattern DP2 may include the same material as the first data metal layer including the first connection electrode CE1 and the data lines and may be disposed on the same layer. In an embodiment, for example, the second dummy pattern DP2 may be disposed on the second interlayer-insulating layer 142. The second dummy pattern DP2 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second dummy pattern DP2 may overlap the first dummy pattern DP1 in the third direction (Z-axis direction).

The first to eighth tips T1 to T8 may include the same material as the second data metal layer including the second connection electrode CE2 and may be disposed on the same layer. In an embodiment, for example, the first to eighth tips T1 to T8 may be disposed on the first organic layer 160. The first to eighth tips T1 to T8 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

Each of the first to eighth tips T1 to T8 may be connected to the second dummy pattern DP2 through a contact hole penetrating the first organic layer 160. Each of the first to eighth tips T1 to T8 may include an eaves structure in which the top surface and the bottom surface are exposed without being covered by the first organic layer 160, the second organic layer 180, the first hole dam HDAM1, and the second hole dam HDAM2. The fourth tip T4 and the fifth tip T5 may be integrally formed. Each of the first to eighth tips T1 to T8 may be a protruding pattern or a trench pattern for forming a groove (or trench).

A distance from the eighth tip T8 to the edge TEG of the through-hole TH may be approximately 300 µm. The through-hole edge area TEGA may be disposed between the eighth tip T8 and the edge TEG of the through-hole TH. A hole protection dam HCPD may be disposed between the eighth tip T8 and the through-hole edge area TEGA.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have an eaves structure formed by the first tip T1 and the second tip T2, the second groove GR2 may have an eaves structure formed by the third tip T3 and the fourth tip T4, and the third groove GR3 may have an eaves structure formed by the fifth tip T5 and the sixth tip T6.

Since the light emitting layer 172 is deposited by evaporation and the common electrode 173 is deposited by sputtering, the light emitting layer 172 and the common electrode 173 may be disposed to be broken at each of the first to third grooves GR1, GR2, and GR3 because the step coverage is low. In contrast, the first encapsulation inorganic layer TFE1 and the second encapsulation inorganic layer TFE3 may be deposited by chemical vapor deposition, atomic layer deposition, or the like, and thus may be formed to be continuous without being broken in each of the first to third grooves GR1, GR2, and GR3 because the step coverage is high. The light emitting layer 172, a broken light emitting layer remnant 172_D, the common electrode 173, and a broken common electrode remnant 173_D may be disposed in the first to third grooves GR1, GR2, and GR3, respectively.

The first hole dam HDAM1 may include first to fourth hole sub-dams HDA1, HDA2, HDA3, and HDA4. The first hole sub-dam HDA1 may be disposed on the first organic layer 160 and may include the same material as the second organic layer 180. The first hole sub-dam HDA1 may be disposed on the second tip T2 and the third tip T3. The second hole sub-dam HDA2 may be disposed on the first hole sub-dam HDA1 and may include the same material as the pixel defining layer 190. The third hole sub-dam HDA3 and the fourth hole sub-dam HDA4 may be disposed on the second hole sub-dam HDA2 and may include the same material as the spacer 191, but are not limited thereto. The fourth hole sub-dam HDA4 may be disposed closer to the through-hole TH than the third hole sub-dam HDA3. The thickness of the fourth hole sub-dam HDA4 may be greater than the thickness of the third hole sub-dam HDA3.

The second hole dam HDAM2 may include fifth to seventh hole sub-dams HDA5, HDA6, and HDA7. The fifth hole sub-dam HDA5 may be disposed on the first organic layer 160 and may include the same material as the second organic layer 180. The fifth hole sub-dam HDA5 may be disposed on the seventh tip T7. The sixth hole sub-dam HDA6 may be disposed on the fifth hole sub-dam HDA5 and may include the same material as the pixel defining layer 190. The seventh hole sub-dam HDA7 may be disposed on the sixth hole sub-dam HDA6 and may include the same material as the spacer 191, but is not limited thereto.

The overflow of the encapsulation organic layer TFE2 into the through-hole TH may be prevented by the first hole dam HDAM1 and the second hole dam HDAM2.

The light emitting layer remnant 172_D, the common electrode remnant 173_D, the first encapsulation inorganic layer TFE1, and the second encapsulation inorganic layer TFE3 may extend to the edge TEG of the through-hole TH. The end of the light emitting layer remnant 172_D, the end of the common electrode remnant 173_D, the end of the first encapsulation inorganic layer TFE1, or the end of the second encapsulation inorganic layer TFE3 may coincide with the edge TEG of the through-hole TH. However, the present disclosure is not limited thereto, and the end of the light emitting layer remnant 172_D, the end of the common electrode remnant 173_D, the end of the first encapsulation inorganic layer TFE1, or the end of the second encapsulation inorganic layer TFE3 may not coincide with the edge TEG of the through-hole TH in another embodiment.

As illustrated in FIG. 14, since the light emitting layer 172 and the common electrode 173 are broken in the first to third grooves GR1, GR2, and GR3 formed by the first to eighth tips T1 to T8, respectively, it is possible to prevent the light emitting layer 172 and the common electrode 173 exposed through the through-hole TH from being a path through which oxygen, moisture, or the like permeates.

The display device 10 according to the present embodiment may include a hole protection dam HCPD disposed between the eighth tip T8 and the through-hole edge area TEGA. The hole protection dam HCPD may have substantially the same component as the protection dam CPD described above with reference to FIG. 7 or the like. In an embodiment, for example, the hole protection dam HCPD may include the same material as the protection dam CPD of FIG. 7 and may be disposed at the same position. In addition, the distance between the hole protection dam HCPD and the edge TEG of the through-hole TH may be applied in the same manner as the distance between the protection dam CPD and the edge EG of the display panel 100 illustrated in FIG. 7 or the like. Accordingly, a detailed description of the hole protection dam HCPD will be omitted.

Hereinafter, other embodiments of the protection dam according to an embodiment will be described. In the following embodiments, description of the same components as those of the above-described embodiment, which are denoted by like reference numerals, will be omitted or simplified, and differences will be mainly described.

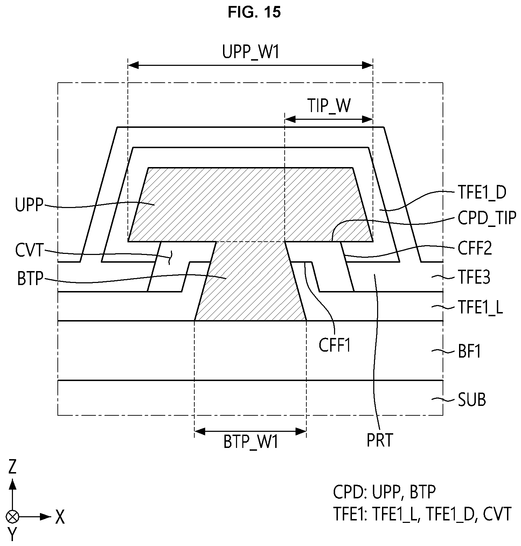

FIG. 15 is a cross-sectional view illustrating a protection dam and the surroundings thereof according to another embodiment.

Referring to FIG. 15, the protection dam CPD according to the present embodiment is different from the protection dam CPD according to an embodiment described with reference to FIG. 9 or the like in that the length TIP_W of the protection tip CPD_TIP is longer.

More specifically, in the display device 10 according to the present embodiment, the length TIP_W of the protection tip CPD_TIP of the protection dam CPD may be longer than the length TIP_W of the protection tip CPD_TIP of the protection dam CPD according to an embodiment described with reference to FIG. 9 or the like. In an embodiment, for example, as the difference between the width UPP_W1 of the upper portion UPP and the width BTP_W1 (e.g., maximum width) of the lower portion BTP of the protection dam CPD increases, the length TIP_W of the protection tip CPD_TIP may increase.

As the length TIP_W of the protection tip CPD_TIP increases, the step coverage of the first encapsulation inorganic layer TFE1, which is the upper layer, is lowered, so that the first encapsulation inorganic layer TFE1, which is the upper layer, may be broken. In an embodiment, for example, the first encapsulation inorganic layer TFE1 may include a remaining portion TFE1_D, and an extension portion TFE1_L, and define a cavity portion CVT.

The remaining portion TFE1_D may be disposed on the protection dam CPD. In an embodiment, for example, the remaining portion TFE1_D may be disposed on the upper portion UPP of the protection dam CPD. The extension portion TFE1_L may be disposed on opposite sides of the protection dam CPD. In an embodiment, for example, the extension portion TFE1_L may cover portions of opposite side surfaces of the lower portion BTP of the protection dam CPD on the first buffer layer BF1 therein.

The cavity portion CVT may be formed between a first cutoff portion CFF1, which is one end of the extension portion TFE1_L, and a second cutoff portion CFF2, which is one end of the remaining portion TFE1_D. As the length TIP_W of the protection tip CPD_TIP increases, the step coverage of the first encapsulation inorganic layer TFE1 is lowered, so that the first encapsulation inorganic layer TFE1 may be formed by being cut off into the remaining portion TFE1_D and the extension portion TFE1_L, and the cavity portion CVT. The cavity portion CVT may be a cavity, that is, an empty space, formed between the first cutoff portion CFF1 and the second cutoff portion CFF2.

The second encapsulation inorganic layer TFE3 may include a protrusion portion PRT. The protrusion portion PRT may be a portion protruding toward the cavity portion CVT of the first encapsulation inorganic layer TFE1. In an embodiment, for example, the protrusion portion PRT may refer to a portion protruding from the second encapsulation inorganic layer TFE3 positioned on the left side of the protection dam CPD to the right side, which is a direction toward the cavity portion CVT, and a portion protruding from the second encapsulation inorganic layer TFE3 positioned on the right side of the protection dam CPT to the left side, which is a direction toward the cavity portion CVT.

In the drawing, it is illustrated that the end boundary of the protrusion portion PRT and the end boundary of the second cutoff portion CFF2 coincide, but the present disclosure is not limited thereto. This may vary depending on the step coverage of the second encapsulation inorganic layer TFE3, and the size and shape of the cavity portion CVT may vary depending on the extent to which the end of the protrusion portion PRT permeates into the cavity portion CVT.

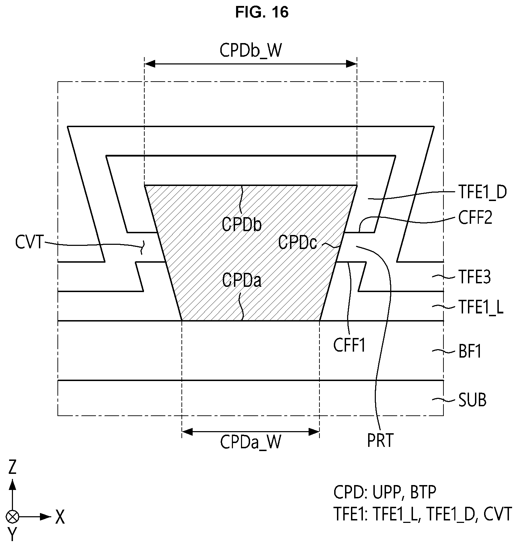

FIG. 16 is a cross-sectional view illustrating a protection dam and the surroundings thereof according to still another embodiment.

Referring to FIG. 16, the protection dam CPD according to the present embodiment is different from the protection dam CPD according to the embodiments described with reference to FIGS. 9 and 15 or the like in that the protection dam CPD has a reverse tapered trapezoidal shape.

In FIG. 16, the upper portion UPP and the lower portion BTP of FIGS. 9 and 15 are not illustrated, but it may be regarded that the protection dam CPD includes the upper portion UPP and the lower portion BTP by dividing the upper portion UPP and the lower portion BTP with respect to an optional dividing line. That is, hereinafter, for simplicity of description, the protection dam CPD is described exemplarily as having one component, but is not limited thereto.

More specifically, the protection dam CPD may have a reverse tapered trapezoidal shape. In an embodiment, for example, the protection dam CPD may include a bottom surface CPDa, a top surface CPDb, and a side surface CPDc. A width CPDa_W of the bottom surface CPDa of the protection dam CPD may be smaller than a width CPDb_W of the top surface CPDb. Accordingly, the side surface CPDc of the protection dam CPD may be formed as an inclined surface toward the interior direction of the protection dam CPD in a direction from the top surface CPDb to the bottom surface CPDa. That is, the shape of the side surface CPDc of the protection dam CPD may be a reverse tapered shape.

The drawing exemplarily illustrates that the first encapsulation inorganic layer TFE1 has a cut structure, but as in an embodiment described with reference to FIG. 9, the first encapsulation inorganic layer TFE1 may have a connected structure. This may vary depending on the step coverage of the first encapsulation inorganic layer TFE1 according to the difference between the width CPDa_W of the bottom surface CPDa and the width CPDb_W of the top surface CPDb of the protection dam CPD. Hereinafter, for simplicity of description, a structure in which the first encapsulation inorganic layer TFE1 is cut will be described as an example.

The first encapsulation inorganic layer TFE1 may include the remaining portion TFE1_D, the extension portion TFE1_L, and define the cavity portion CVT therein. The extension portion TFE1_L and the remaining portion TFE1_D may include the first cutoff portion CFF1 and the second cutoff portion CFF2, respectively. Since the remaining portion TFE1_D, the extension portion TFE1_L, and the cavity portion CVT are similar to those described above with reference to FIG. 15, description thereof will be omitted.

The second encapsulation inorganic layer TFE3 may include the protrusion portion PRT. The drawings illustrate that the protrusion portion PRT completely fills the cavity portion CVT of the first encapsulation inorganic layer TFE1, but is not limited thereto. For another example, when the step coverage of the second encapsulation inorganic layer TFE2 is lowered due to the stepped portion caused by the second cutoff portion CFF2 of the first encapsulation inorganic layer TFE1, the cavity portion CVT may not be completely filled, and an empty space may be formed.

Hereinafter, a method for manufacturing a display device according to an embodiment will be described.

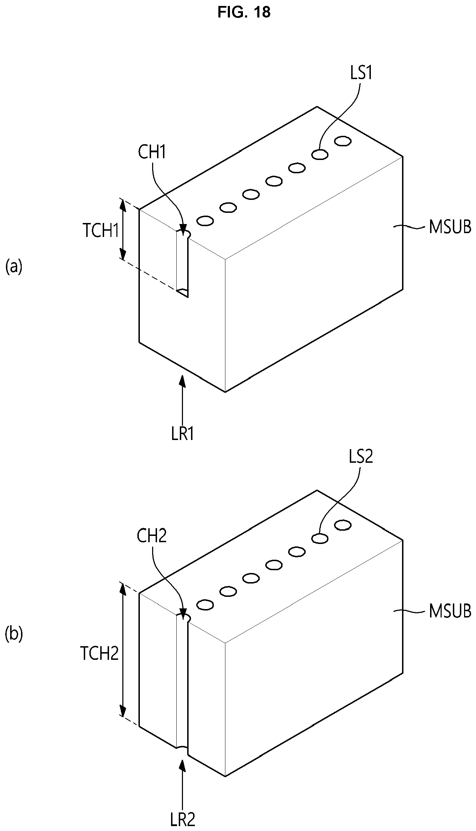

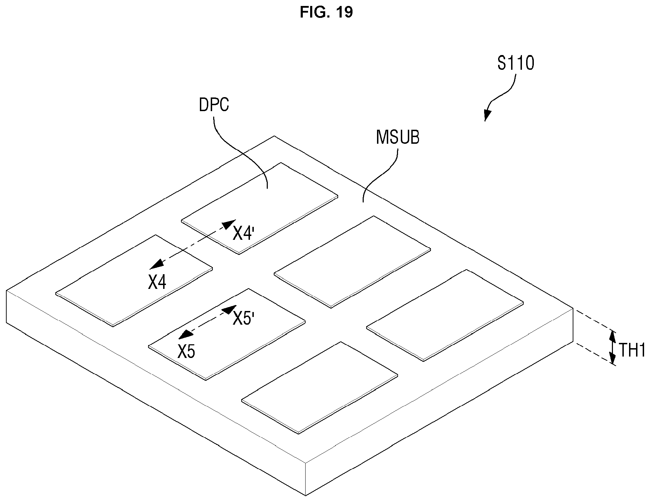

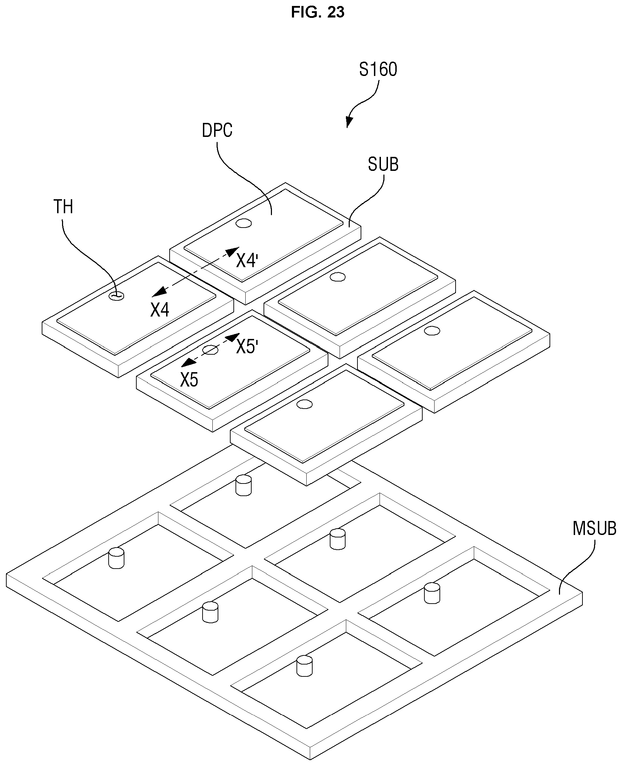

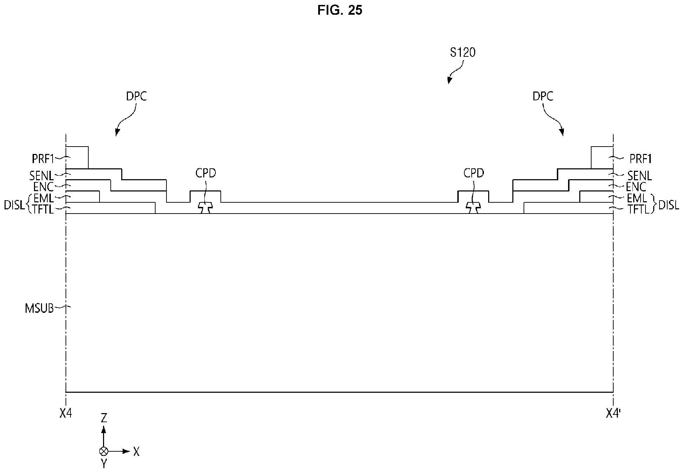

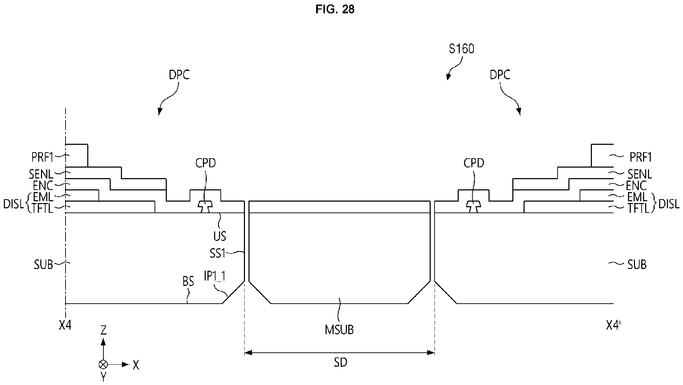

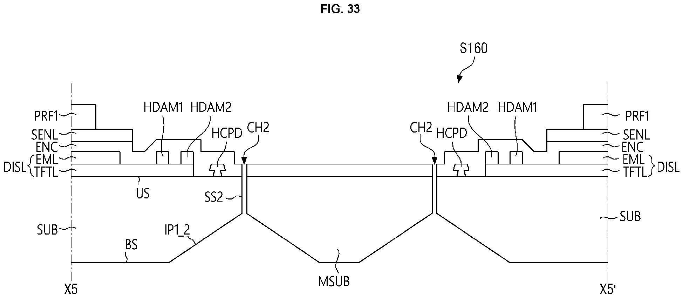

FIG. 17 is a flowchart showing a method for manufacturing a display device according to an embodiment. FIG. 18 is a diagram illustrating the depth of a laser irradiation area formed by a laser processing device according to an embodiment. FIGS. 19 to 24 are perspective views illustrating a method for manufacturing a display device according to an embodiment. FIGS. 25 to 34 are cross-sectional views illustrating a method for manufacturing a display device according to an embodiment.

Referring to FIGS. 17 to 34, in the manufacturing method S1 of the display device according to an embodiment, firstly, as illustrated in FIG. 19, a plurality of display cells DPC are formed on the first surface of the mother substrate MSUB (step S110 of FIG. 17).

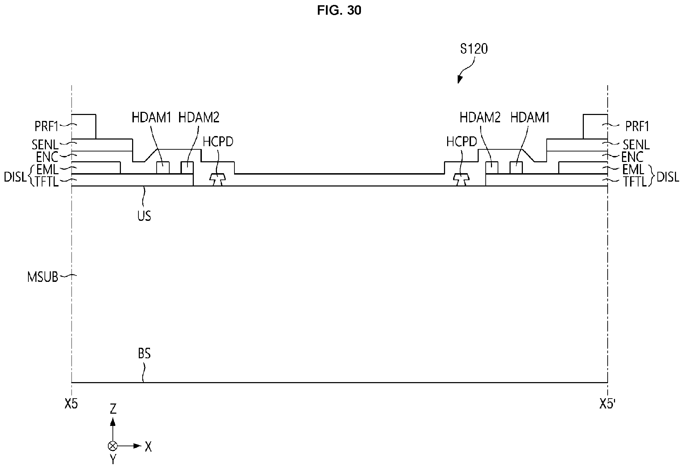

Secondly, as illustrated in FIGS. 25 and 30, a plurality of first protective films PRF1 are attached to the plurality of display cells DPC, and the plurality of display cells DPC are inspected (step S120 of FIG. 17).

First, a first protective film layer is attached to cover the plurality of display cells DPC and the mother substrate MSUB disposed between the plurality of display cells DPC. Then, by removing a portion of the first protective film layer disposed on the mother substrate MSUB, the plurality of first protective films PRF1 may be disposed on the plurality of display cells DPC, respectively. That is, a part of the first protective film layer may be removed, and the remainder may be the plurality of first protective films PRF1. Accordingly, the plurality of first protective films PRF1 may be disposed on the plurality of display cells DPC, respectively. That is, the plurality of first protective films PRF1 may be disposed in a one-to-one correspondence with the plurality of display cells DPC.

Each of the plurality of first protective films PRF1 may be a buffer film for protecting the plurality of display cells DPC from external impact. The plurality of first protective films PRF1 may be made of a transparent material.

Then, the plurality of display cells DPC are inspected using an inspection device. After connecting a probe to a plurality of test pads provided on each of the plurality of display cells DPC, a lighting test of each of the plurality of display cells DPC may be performed.

When the lighting test is performed after separating the plurality of display cells DPC from the mother substrate MSUB by the cutting process, an additional process for removing the plurality of test pads is required after completing the lighting test. On the other hand, when the lighting test is performed on the mother substrate MSUB, the plurality of test pads are removed when the plurality of display cells DPC are separated from the mother substrate MSUB through laser irradiation and etching later. Accordingly, when the lighting test is performed on the mother substrate MSUB, there is an advantage in that no additional process for removing the plurality of test pads is required.

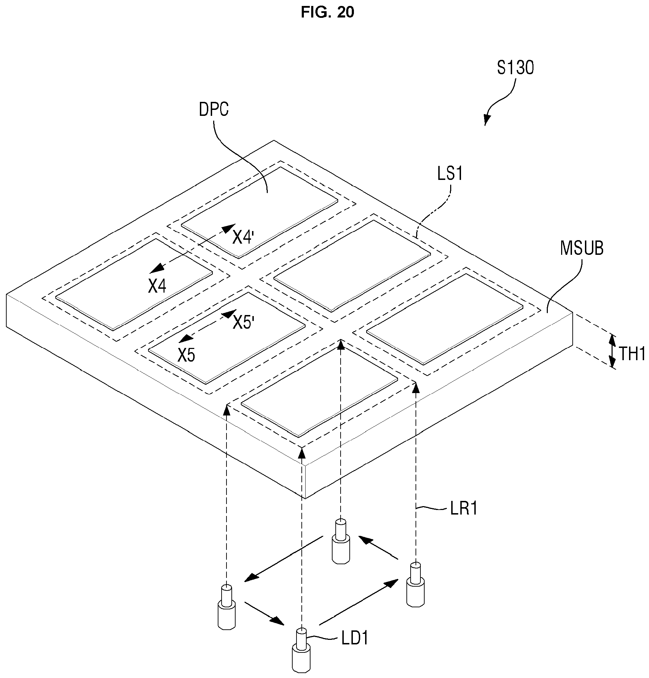

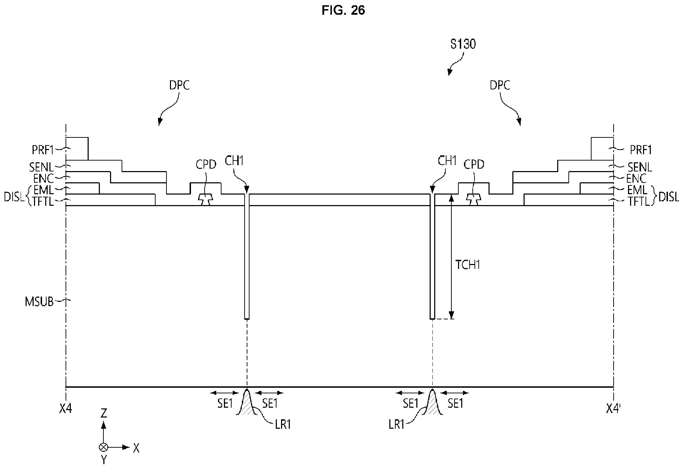

Thirdly, as illustrated in FIGS. 20 and 26, a plurality of first laser irradiation areas CH1 disposed along the edges of the plurality of display cells DPC are formed by irradiating first laser LR1 onto the second surface that faces the first surface of the mother substrate MSUB (step S130 of FIG. 17).

Although various types of lasers may be used as the first laser LR1 according to an embodiment, the present specification exemplifies that the first laser LR1 is an infrared Bessel beam having a wavelength of approximately 1030 nm.

As illustrated in FIGS. 20 and 26, the first laser LR1 may be irradiated on the second surface of the mother substrate MSUB. However, the embodiments of the present specification are not limited thereto. The first laser LR1 may be irradiated on the first surface of the mother substrate MSUB in another embodiment.

A first sketch line LS1 may be defined as an imaginary line connecting the plurality of first laser irradiation areas CH1. The first sketch line LS1 may be formed by irradiating the first laser LR1 to form the plurality of first laser irradiation areas CH1 along edges of the plurality of display cells DPC.

A one-side tolerance SE1 of the first laser LR1 may be within approximately 50 µm, and the opposite-sides tolerance of the first laser LR1 may be within approximately 100 µm. The one-side tolerance SE1 of the first laser LR1 may be a cutting error in one direction (e.g., the X-axis direction) when the plurality of first laser irradiation areas CH1 are formed by the first laser LR1.

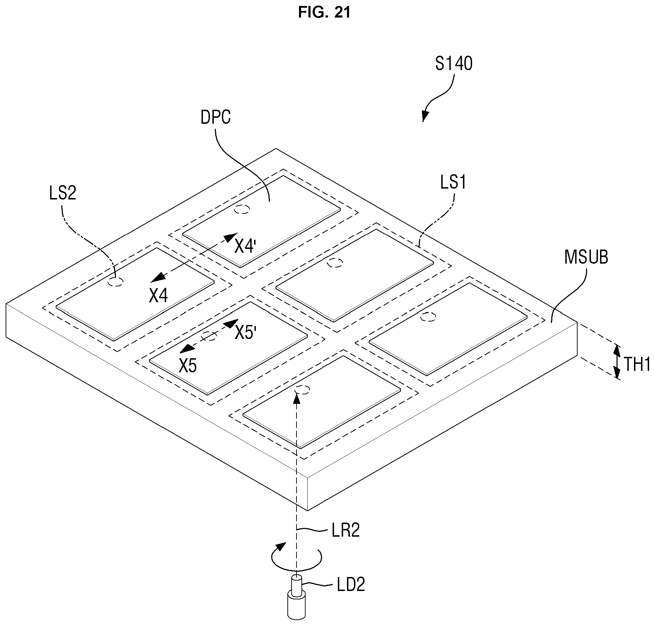

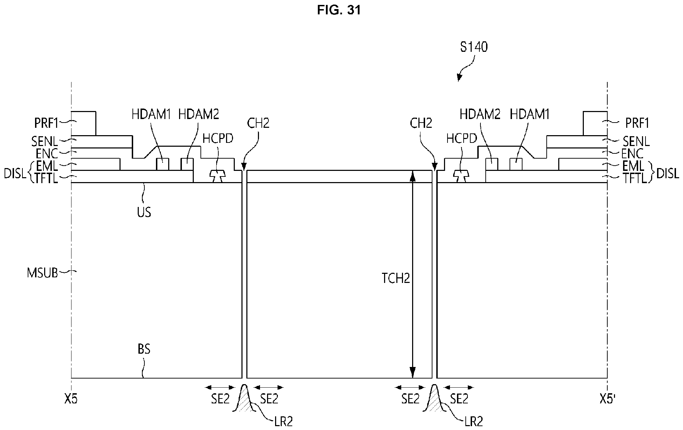

Fourthly, as illustrated in FIGS. 21 and 31, a plurality of second laser irradiation areas CH2 for forming the through-hole TH in each of a plurality of display cells are formed by irradiating second laser LR2 onto the second surface of the mother substrate MSUB (step S140 of FIG. 17).

Although FIG. 21 illustrates that the step S140 is performed after the step S130 is performed, the embodiment of the present specification is not limited thereto. In order to reduce the process time, the step S130 and the step S140 may be performed simultaneously by providing a plurality of laser processing devices LD1 and LD2. Alternatively, the step S130 may be performed after the step S140.

Although various types of lasers may be used as the second laser LR2 according to an embodiment, the present specification exemplifies that the second laser LR2 is an infrared Bessel beam having a wavelength of approximately 1030 nm.

As illustrated in FIGS. 21 and 31, the second laser LR2 may be irradiated on the second surface of the mother substrate MSUB. However, the embodiments of the present specification are not limited thereto. The second laser LR2 may be irradiated on the first surface of the mother substrate MSUB in another embodiment.

The second sketch line LS2 may be defined as an imaginary line connecting the plurality of second laser irradiation areas CH2. The second sketch line LS2 may be formed by irradiating the second laser LR2 to form the plurality of second laser irradiation areas CH2 along the edge of the through-hole TH. The second sketch line LS2 may depend on the shape of the through-hole. In an embodiment, for example, when the through-hole TH has a circular planar shape, the second sketch line LS2 may be formed in a circular shape.

A one-side tolerance SE2 of the second laser LR2 may be within approximately 50 µm, and the opposite-sides tolerance of the second laser LR2 may be within approximately 100 µm. The one-side tolerance SE2 of the second laser LR2 may be a cutting error in one direction (e.g., the X-axis direction) when the plurality of second laser irradiation areas CH2 are formed by the second laser LR2.

When the first laser LR1 and the second laser LR2 are irradiated on the second surface of the mother substrate MSUB, as illustrated in FIG. 18, a depth TCH1 (or a sketch length) of each of the plurality of first laser irradiation areas CH1 and a depth TCH2 (or a sketch length) of each of the plurality of second laser irradiation areas CH2 may be adjusted according to a repetition rate, a processing speed, and pulse energy.

In an embodiment, for example, the depth TCH1 of each of the plurality of first laser irradiation areas CH1 may be approximately 50 µm from the first surface of the mother substrate MSUB as illustrated in FIG. 18A. In addition, since the thickness of the mother substrate MSUB is approximately 500 µm, the depth TCH2 of each of the plurality of second laser irradiation areas CH2 may be approximately 500 µm. That is, the depth TCH2 of each of the plurality of second laser irradiation areas CH2 may be approximately 50 µm to 500 µm from the first surface of the mother substrate MSUB. However, as illustrated in FIG. 18B, when the plurality of second laser irradiation areas CH2 are formed up to the encapsulation layer ENC, the depth TCH2 of each of the plurality of second laser irradiation areas CH2 may be greater than 500 µm.

The first laser LR1 for forming the first laser irradiation areas CH1 may be irradiated with a repetition rate of 10 kHz to 250 kHz, a processing speed of 10 millimeters per second (mm/s) to 250 mm/s, and pulse energy of 10 microjoules (µJ) to 300 µJ. However, in order for the first laser LR1 to have a depth of approximately 225 µm from the first surface of the mother substrate MSUB, it is preferable to perform irradiation with a repetition rate of approximately 17.5 kHz to 125 kHz, a processing speed of 17.5 mm/s to 125 mm/s, and pulse energy of 25 µJ to 178 µJ.

The second laser LR2 for forming the second laser irradiation areas CH2 may be irradiated with a repetition rate of 1 kHz to 50 kHz, a processing speed of 1 mm/s to 50 mm/s, and pulse energy of 10 µJ to 300 µJ. However, in order for the second laser LR2 to have a depth of approximately 400 µm to 500 µm from the first surface of the mother substrate MSUB, irradiation may be performed with a repetition rate of approximately 10 kHz, a processing speed of 10 mm/s, and pulse energy of 60 µJ to 178 µJ. In particular, while the second laser LR2 forms the circular second sketch line LS2, the first laser LR1 forms the first sketch line LS1 along the edge of each of the plurality of display cells DPC, so that the processing speed of the second laser LR2 may be smaller than the processing speed of the first laser LR1.

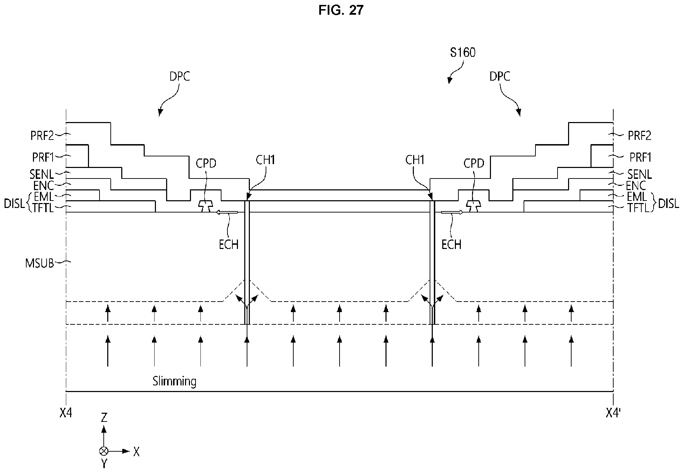

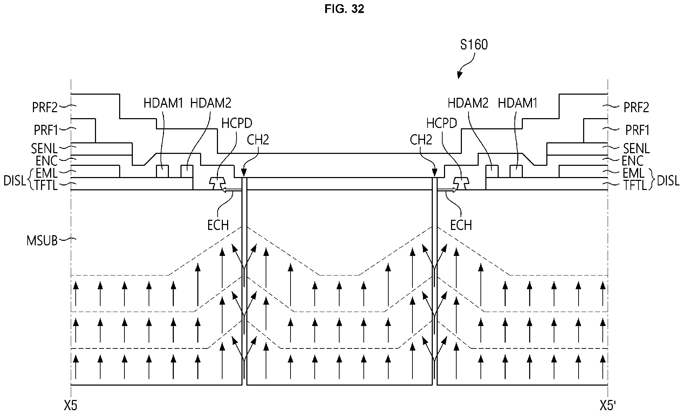

Fifthly, as illustrated in FIGS. 27 and 32, a second protective film PRF2 is attached to the plurality of first protective films PRF1 (step S150 of FIG. 17).

The second protective film PRF2 may be attached to the plurality of first protective films PRF1 and the exposed mother substrate MSUB that is not covered by the plurality of first protective films PRF1. The second protective film PRF2 may cover the plurality of first laser irradiation areas CH1 and the plurality of second laser irradiation areas CH2. The second protective film PRF2 may be an acid-resistant film for protecting the plurality of display cells DPC from the etchant in an etching process of the mother substrate MSUB to be performed in the next step.

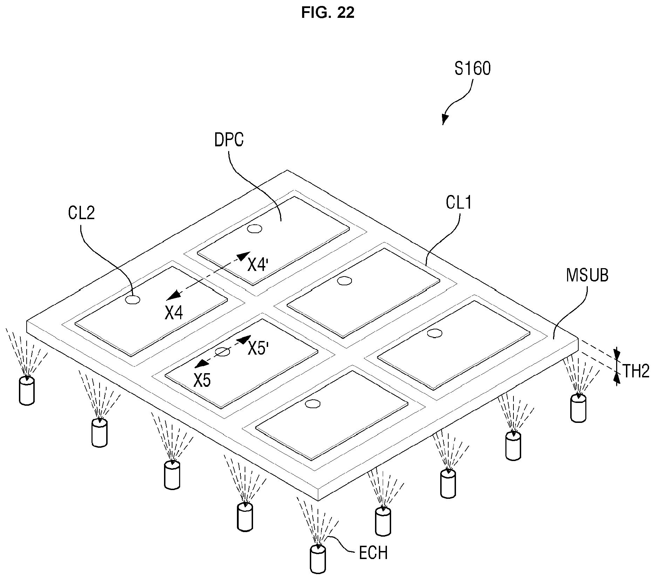

Sixthly, as illustrated in FIGS. 22, 23, 27, 28, 32, and 33, the etchant is sprayed on the second surface of the mother substrate MSUB without a separate mask to reduce the thickness of the mother substrate MSUB, the mother substrate is cut along the plurality of first laser irradiation areas CH1 and the plurality of second laser irradiation areas CH2, and the second protective film PRF2 is detached (step S160 of FIG. 17).

When the etchant is sprayed on the second surface of the mother substrate MSUB, the mother substrate MSUB may be reduced from the first thickness TH1 to the second thickness TH2. Since the mother substrate MSUB is etched without a separate mask, isotropic etching in which the mother substrate MSUB is uniformly etched over the entire area of the second surface may be performed.

Each of the plurality of first laser irradiation areas CH1 may include a physical hole formed by the first laser LR1 and an area around the physical hole of which physical properties are changed by the laser. Alternatively, each of the plurality of first laser irradiation areas CH1 may be an area of which physical properties are changed by the first laser LR1 without a physical hole. Accordingly, the etching rate in each of the plurality of first laser irradiation areas CH1 by the etchant may be higher than the etching rate in other areas of the mother substrate MSUB to which the laser is not irradiated.

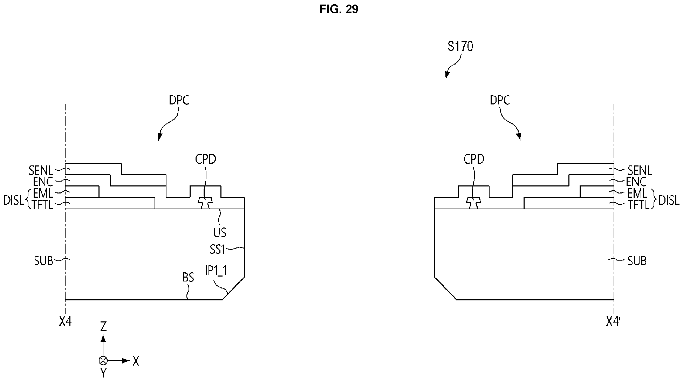

When the thickness of the mother substrate MSUB is reduced by the etchant and the etchant permeates into the plurality of first laser irradiation areas CH1 formed by the first laser LR1, due to the plurality of first laser irradiation areas CH1, a difference may occur in etching rates between an area in which the first laser irradiation areas CH1 are formed and an area in which the first laser irradiation areas CH1 are not formed. That is, the mother substrate MSUB may be performed with anisotropic etching in which the etching rate in the area in which the first laser irradiation areas CH1 are formed is faster than the etching rate in the area in which the first laser irradiation areas CH1 are not formed. Accordingly, as illustrated in FIG. 29, the substrate SUB separated from the mother substrate MSUB may include the first inclined surface IP1_1 disposed between the side surface SS1 and the bottom surface BS.

In addition, as the etchant permeates into the plurality of first laser irradiation areas CH1 formed by the first laser LR1, the mother substrate MUSB may be separated along a first cutting line CL1. That is, each of the plurality of display cells DPC may be separated from the mother substrate MSUB. The first cutting line CL1 may be formed along the first sketch line LS1.

Since the first surface of the substrate SUB separated from the mother substrate MSUB is not permeated by the etchant due to the second protective film but the second surface of the substrate SUB is etched by the etchant, the first surface and the second surface of the substrate SUB may have differences in roughness, hardness, light transmittance, light reflectivity, local density, surface chemical structure, or the like. In an embodiment, for example, dimples due to the etchant may occur on the second surface of the substrate MSUB. The dimple indicates that a fine defect such as a scratch present on the second surface of the substrate SUB is enlarged by reacting with the etchant.

The one-side tolerance of the laser may be approximately 50 µm, and the width of the first laser irradiation area CH1 formed by the first laser LR1 may be expanded by approximately 40 µm by the etchant. Accordingly, considering the opposite-sides tolerance of the laser of each of the display cells DPC and the width of the first laser irradiation area CH1 expanded by the etchant, a separation distance SD between the display cells DPC adjacent to each other may be approximately 280 µm.

Each of the plurality of second laser irradiation areas CH2 may include a physical hole formed by the second laser LR2 and an area around the physical hole of which physical properties are changed by the laser. Alternatively, each of the plurality of second laser irradiation areas CH2 may be an area of which physical properties are changed by the second laser LR2 without a physical hole. Accordingly, the etching rate in each of the plurality of second laser irradiation areas CH2 by the etchant may be higher than the etching rate in other areas of the mother substrate MSUB to which the laser is not irradiated.

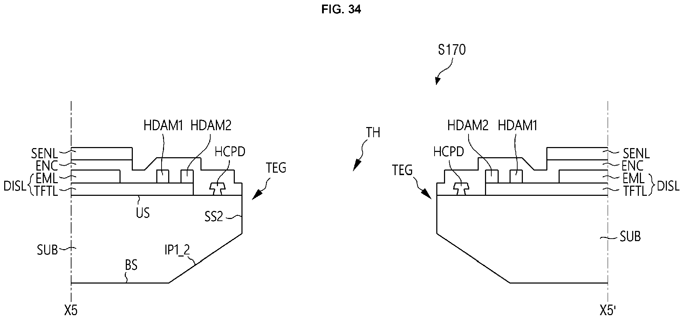

Due to the anisotropic etching, as illustrated in FIG. 34, the substrate SUB separated from the mother substrate MSUB may include the second inclined surface IP1_2 disposed between the bottom surface BS and the side surface SS2 of the edge TEG of the through-hole TH.

In addition, as the etchant permeates into the plurality of second laser irradiation areas CH2 formed by the second laser LR2, the mother substrate MUSB may be separated along a second cutting line CL2 to form the through-hole TH. The second cutting line CL2 may be formed along the second sketch line LS2.

As illustrated in FIGS. 27 and 32, since the depth of each of the plurality of second laser irradiation areas CH2 is deeper than the depth of each of the plurality of first laser irradiation areas CH1, the etchant may permeate into the plurality of second laser irradiation areas CH2 earlier than the plurality of first laser irradiation areas CH1. That is, since the plurality of second laser irradiation areas CH2 are etched along with a slimming process in which the thickness of the mother substrate MSUB is reduced by the etchant, the substrate SUB forms a tapered cross section by isotropic etching in the through-hole TH formed by the second laser irradiation area CH2. In comparison, the plurality of first laser irradiation areas CH1 are not etched when slimming is performed. Accordingly, a difference may occur between the length and angle of the inclination direction of the first inclined surface IP1_1 in the edge of the substrate SUB formed by the plurality of first laser irradiation areas CH1, and the length and angle of the inclined direction of the second inclined surface IP1_2 in the through-hole TH formed by the plurality of second laser irradiation areas CH2.

After the etching process is completed, the second protective film PRF2 may be detached.

Through the etching process, each of the plurality of display cells DPC may be separated from the mother substrate MSUB, and the through-hole TH may be formed in each of the plurality of display cells DPC.

In the manufacturing method S1 of the display device according to the present embodiment, by including the protection dam CPD and the hole protection dam HCPD adjacent to the through-hole TH as the outermost structure, as described above, the permeation of the etchant ECH toward the display layer DISL may be effectively prevented. Accordingly, the separation distance SD between the display cells DPC may be further reduced, and the non-display area NDA of the display device 10 may be effectively minimized.

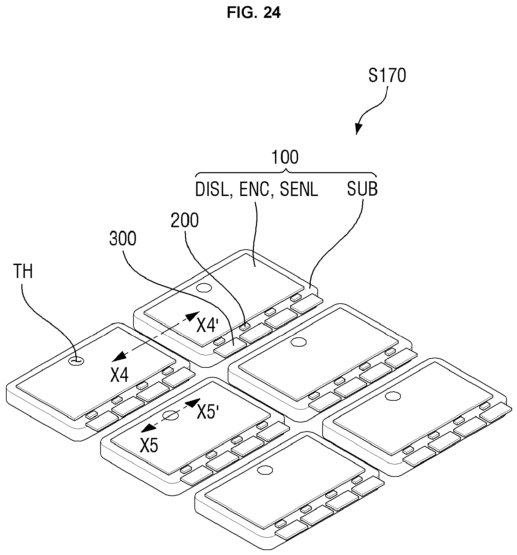

Seventhly, as illustrated in FIGS. 24, 29 and 34, the driving IC 200 and the circuit board 300 are attached to each of the plurality of display cells DPC, and the first protective film PRF1 is detached from each of the plurality of display cells DPC (step S170 of FIG. 17).

As described above, by using the laser and the etching process, the thickness of the substrate SUB may be reduced, the substrate SUB of each of the plurality of display cells DPC may be separated from the mother substrate MSUB, and at the same time the through-hole TH may be formed, so that the efficiency of the manufacturing process may be increased.

In concluding the detailed description, those skilled in the art will appreciate that many variations and modifications can be made to the preferred embodiments without substantially departing from the principles and scope of the of the present disclosure as defined by the appended claims. Therefore, the disclosed preferred embodiments of the invention are used in a generic and descriptive sense only and not for purposes of limitation.

## Claims

1. A display device (1, 10) comprising:
a substrate (SUB) comprising a first surface (US), a second surface (BS) facing the first surface (US), and a first side surface (SS1) between the first surface (US) and the second surface (BS);
a plurality of light emitting elements (LEL) on the first surface (US); and
a protection dam (CPD) on the first surface (US), and adjacent to an edge of the substrate (SUB), wherein the protection dam (CPD) comprises a lower portion (BTP) and an upper portion (UPP) on the lower portion (BTP), and
a width (UPP_W1) of the upper portion (UPP) is greater than a maximum width (BTP_W1) of the lower portion (BTP).

2. The display device (1, 10) of claim 1, the substrate (SUB) further comprising a first inclined surface (IP1_1) between the first side surface (SS1) and the second surface (BS), wherein the substrate (SUB) is optionally made of glass.

3. The display device (1, 10) of claim 1 or 2, wherein a first extension line (EXL1) connecting a lower end of the upper portion (UPP) to a lower end of the lower portion (BTP) and a second extension line (EXL2) connecting an opposite lower end of the upper portion (UPP) to an opposite lower end of the lower portion (BTP) form a reverse tapered shape.

4. The display device (1, 10) of any one of the preceding claims, wherein the upper portion (UPP) comprises a first tip (T1) protruding from the lower portion (BTP).

5. The display device (1, 10) of claim 4, further comprising a first upper layer on the protection dam (CPD), wherein
the first upper layer covers a top surface (CPDb) and a side surface (CPDc) of the protection dam (CPD), and
the first upper layer comprises a second tip (T2) along a shape of the first tip (T1).

6. The display device (1, 10) of claim 5, further comprising:
a thin film transistor layer (TFTL) on the first surface (US); and
an encapsulation layer (ENC) on the plurality of light emitting elements (LEL), wherein
each of the thin film transistor layer (TFTL) and the encapsulation layer (ENC) comprises at least one of an inorganic layer (TFE1, TFE3) or an organic layer (TFE2), and
the first upper layer is the at least one of the inorganic layer (TFE1, TFE3) or the organic layer (TFE2) of the thin film transistor layer (TFTL) or the encapsulation layer (ENC).

7. The display device (1, 10) of any one of claims 1 to 4, further comprising a first upper layer on the protection dam (CPD), wherein
the first upper layer comprises:
a remaining portion (TFE1_D) on a top surface (CPDb) of the protection dam (CPD); and
an extension portion (TFE1_L) on at least one side surface (CPDc) of the protection dam (CPD), and
the first upper layer defines a cavity portion (CVT) between the remaining portion (TFE1_D) and the extension portion (TFE1_L).

8. The display device (1, 10) of claim 7, wherein the remaining portion (TFE1_D) and the extension portion (TFE1_L) overlap the protection dam (CPD) in a thickness direction (Z-axis).

9. The display device (1, 10) of claim 7 or 8, further comprising a second upper layer on the first upper layer,
wherein the second upper layer is disposed in at least a part of the cavity portion (CVT) defined in the first upper layer.

10. The display device (1, 10) of any one of the preceding claims, wherein:
the protection dam (CPD) contains at least one organic material of polyimide, polyamide, polyethylene, polypropylene, polyvinyl chloride, PVC, polyester, polyolefin, carbon fiber, and carbon fiber-reinforced epoxy resin; and/or
the protection dam (CPD) includes silicon nitride (SiNx) as an inorganic material; and/or
the protection dam (CPD) contains at least one metal of vanadium, niobium, tantalum, chromium, molybdenum, tungsten, nickel, titanium, palladium, platinum, copper, silver, gold, aluminum, titanium/tungsten (Ti/W), nickel/chromium (Ni/Cr), titanium nitride (TiN), copper/zeolite (Cu/Z), carbon steel, chromium-nickel-molybdenum steel, and a nickel-chromium-iron alloy.

11. The display device (1, 10) of any one of the preceding claims, wherein:
at least a part of the protection dam (CPD) is configured to react with an etchant (ECH) to be oxidized, and at least a part of the oxidized protection dam (CPD) forms a barrier layer; and/or
the protection dam (CPD) is configured to prevent an etchant (ECH) from moving toward the plurality of light emitting elements (LEL) from the edge.

12. The display device (1, 10) of any one of the preceding claims, wherein the protection dam (CPD) surrounds at least a part of a display area (DA) in which the plurality of light emitting elements (LEL) are disposed.

13. The display device (1, 10) of claim 12, further comprising a crack dam (CRD) between the protection dam (CPD) and the display area (DA).

14. The display device (1, 10) of claim 2, wherein
the substrate (SUB) defines a through-hole (TH) penetrating the first surface (US) and the second surface (BS), and
the substrate (SUB) further includes:
a second side surface (SS2) between the first surface (US) and the second surface (BS) at an edge (TEG) of the through-hole (TH); and
a second inclined surface (IP1_2) between the second side surface (SS2) and the second surface (BS),
wherein a length of the first inclined surface (IP1_1) is shorter than a length of the second inclined surface (IP1_2).

15. The display device (1, 10) of claim 14, wherein an angle (θ3) between the first inclined surface (IP1_1) and the second surface (BS) is smaller than an angle (θ6) between the second inclined surface (IP1_2) and the second surface (BS).

16. A display device (1, 10) comprising:
a substrate (SUB) comprising a first surface (US) and a second surface (BS), which face each other, wherein the substrate (SUB) defines a through-hole (TH) penetrating the first surface (US) and the second surface (BS);
a plurality of light emitting elements (LEL) on the first surface (US); and
a protection dam (HCPD) on the first surface (US), and adjacent to an edge (TEG) of the through-hole (TH),
wherein at the edge (TEG) of the through-hole (TH), the substrate (SUB) further comprises:
a first side surface (SS2) between the first surface (US) and the second surface (BS); and
a first inclined surface (I P1_2) between the first side surface (SS2) and the second surface (BS),
wherein the protection dam (HCPD) comprises a lower portion (BTP) and an upper portion (UPP) on the lower portion (BTP), and
a width (UPP_W1) of the upper portion (UPP) is greater than a maximum width (BTP_W1) of the lower portion (BTP).

17. The display device of any one of the preceding claims, wherein the protection dam (CPD) has a reverse tapered shape or a reverse trapezoidal shape.

18. A method for manufacturing a display device (1, 10), comprising:
forming a plurality of display cells (DPC) on a first surface (US) of a mother substrate (SUB);
forming a plurality of first laser irradiation areas (CH1) defined along edges of the plurality of display cells (DPC) by irradiating a first laser (LR1) onto a second surface (BS) facing the first surface (US) of the mother substrate (SUB); and
cutting the mother substrate (SUB) along the plurality of first laser irradiation areas (CH1) while spraying an etchant (ECH) on the second surface (BS) of the mother substrate (SUB) without a mask to reduce a thickness of the mother substrate (SUB), wherein
a protection dam (CPD) is between the edges of the plurality of display cells (DPC) and the plurality of first laser irradiation areas (CH1),
the protection dam (CPD) comprises a lower portion (BTP) and an upper portion (UPP) on the lower portion (BTP), and
a width (UPP_W1) of the upper portion (UPP) is greater than a maximum width (BTW_W1) of the lower portion (BTP).

19. The method of claim 18, wherein the protection dam (CPD) is configured to prevent the etchant (ECH) from permeating toward a corresponding display cell (DPC) of the plurality of display cells (DPC).

20. The method of claim 18 or 19, further comprising forming a plurality of second laser irradiation areas (CH2) for forming a through-hole (TH) in each of the plurality of display cells (DPC) by irradiating a second laser (LR2) onto the second surface (BS) of the mother substrate (SUB),
wherein in the cutting of the mother substrate (SUB), the through-hole (TH) is formed along the plurality of second laser irradiation areas (CH2) by the etchant (ECH) sprayed without the mask.
